# EUROPÄISCHE PATENTSCHRIFT

(11) **EP 4 187 780 B1**
(45) Veröffentlichungstag und Bekanntmachung des Hinweises auf die Patenterteilung: **17.09.2025**
(21) Anmeldenummer: 23150702.1
(22) Anmeldetag: 04.02.2021
(51) Int. Cl.: H03B 19/14, G01S 7/02, G01S 7/36, G01S 7/40

(54) **FREQUENZGENERATORANORDNUNG MIT LEISTUNGSREGELKEIS, VERWENDUNG UND VERFAHREN**
FREQUENCY GENERATOR ARRANGEMENT WITH POWER CONTROL FEEDBACK CIRCUIT, USE AND PROCESS
DISPOSITIF GÉNÉRATEUR DE FRÉQUENCE AVEC CIRCUIT À RÉGLAGE DE PUISSANCE, UTILISATION ET MÉTHODE

(30) Priorität: 07.02.2020 EP 20156186; 30.06.2020 EP 20183279
(43) Veröffentlichungstag der Anmeldung: 31.05.2023
(62) Teilanmeldung aus: 21702291.2
(73) Patentinhaber: 2pi-Labs GmbH, 44801 Bochum (DE)
(72) Erfinder: JAESCHKE, Timo, 45525 Hattingen (DE); KUEPPERS, Simon, 44879 Bochum (DE)
(74) Vertreter: Von Rohr Patentanwälte Partnerschaft mbB

(56) Entgegenhaltungen:
- US-A- 3 808 539
- US-A1- 2014 139 274
- MURASOV K V ET AL: "The Frequency Doubler 0.4-10 Ghz with Differential Output Based on Gilbert Cell in Si-Ge 130 Nm Technology", 2018 WAVE ELECTRONICS AND ITS APPLICATION IN INFORMATION AND TELECOMMUNICATION SYSTEMS (WECONF), IEEE, 26 November 2018 (2018-11-26), pages 1 - 4, XP033494181, DOI: 10.1109/WECONF.2018.8604347
- ERGINTAV ARZU ET AL: "An integrated 122GHz differential frequency doubler with 37GHz bandwidth in 130 nm SiGe BiCMOS technology", 2017 IEEE MTT-S INTERNATIONAL CONFERENCE ON MICROWAVES FOR INTELLIGENT MOBILITY (ICMIM), IEEE, 19 March 2017 (2017-03-19), pages 53 - 56, XP033091981, DOI: 10.1109/ICMIM.2017.7918854
- YAOMING SUN ET AL: "An integrated harmonic transmitter front-end for 122 GHz FMCW/CW radar sensor", MICROWAVE INTEGRATED CIRCUITS CONFERENCE (EUMIC), 2011 EUROPEAN, IEEE, 10 October 2011 (2011-10-10), pages 97 - 100, XP032073139, ISBN: 978-1-61284-236-3
- MORGAN M ET AL: "A MMIC-BASED 75-110 GHZ SIGNAL SOURCE", 2002 IEEE MTT-S INTERNATIONAL MICROWAVE SYMPOSIUM DIGEST (CAT. NO.02CH37278) IEEE PISCATAWAY, NJ, USA; [IEEE MTT-S INTERNATIONAL MICROWAVE SYMPOSIUM], IEEE, 2 June 2002 (2002-06-02), pages 1859 - 1862, XP001113966, ISBN: 978-0-7803-7239-9, DOI: 10.1109/MWSYM.2002.1012225

## Beschreibung

Die vorliegende Erfindung betrifft eine Frequenzgeneratoranordnung mit einem Oszillator.

Eine Frequenzgeneratoranordnung ist eine Anordnung zur Erzeugung eines bevorzugt zumindest im Wesentlichen monofrequenten Ausgangssignals.

Ein Oszillator im Sinne der vorliegenden Erfindung ist eine elektronische Schaltung, die im Betrieb ein periodisches, insbesondere im Wesentlichen sinusförmiges, Ausgangssignal, im Folgenden Oszillator-Signal genannt, erzeugt. Das Oszillator-Signal ist vorzugsweise zumindest im Wesentlichen monofrequent, enthält also im Wesentlichen eine Frequenz oder eine Frequenz dominiert das Ausgangssignal, was insbesondere dann der Fall ist, wenn diese Frequenz die größte spektrale Leistungsdichte aufweist, im Folgenden Oszillator-Frequenz genannt. Falls der Oszillator ein Oszillator-Signal erzeugt, das mehrere Frequenzanteile enthält, ist die Oszillator-Frequenz diejenige Frequenz, die im Folgenden bzw. durch die mit dem Oszillator gekoppelten Komponenten verwendet wird.

Die Frequenzgeneratoranordnung im Sinne der vorliegenden Erfindung ist vorzugsweise dazu ausgebildet, ein Ausgangssignal zu erzeugen, von dem durch die Frequenzgeneratoranordnung die Ausgangsleistung bzw. Amplitude steuerbar ist.

In diesem Zusammenhang offenbart die DE 10 2014 112 806 A1 einen Radarsensor, bei dem im Sendezweig ein Ein-/Ausschalter vorgesehen ist, der zwischen einem Oszillator und einer Sendeantenne angeordnet ist und die Verbindung zur Sendeantenne dämpft oder unterbricht, während der Oszillator ununterbrochen schwingt und entsprechend ununterbrochen sein Ausgangssignal zur Verfügung stellt, das auch bei Dämpfung oder Unterbrechung durch den Ein-/Ausschalter weiterhin einen Mischer speisen kann, um ein Empfangssignal zu verarbeiten. Die folgenden Dokumente offenbaren Frequenzvervielfältiger-Schaltungen auf: MURASOV K V ET AL: "The Frequency Doubler 0.4-10 Ghz with Differential Output Based on Gilbert Cell in Si-Ge 130 Nm Technology",2018 WAVE ELECTRONICS AND ITS APPLICATION IN INFORMATION AND TELECOMMUNICATION SYSTEMS (WECONF), IEEE, 26. November 2018 (2018-11-26), Seiten 1-4;

ERGINTAV ARZU ET AL: "An integrated 122GHz differential frequency doubler with 37GHz bandwidth in 130 nm SiGe BiCMOS technology",2017 IEEE MTT-S INTERNATIONAL CONFERENCE ON MICROWAVES FOR INTELLIGENT MOBILITY (ICMIM), IEEE, 19. März 2017 (2017-03-19), Seiten 53-56

YAOMING SUN ET AL: "An integrated harmonic transmitter front-end for 122 GHz FMCW/ CW radar sensor",MICROWAVE INTEGRATED CIRCUITS CONFERENCE (EUMIC), 2011 EUROPEAN, IEEE, 10. Oktober 2011 (2011-10-10), Seiten 97-100

Es hat sich gezeigt, dass Ein-/Ausschalter, wie sie aus dem Stand der Technik bekannt sind, insbesondere bei hohen Frequenzen keine ausreichende Isolationswirkung erzeugen, also durch Übersprechen ein Signal nach wie vor zur Sendeantenne gelangt und damit emittiert wird, auch wenn dies nicht beabsichtigt ist. Alternativ den Oszillator zu deaktivieren, ist mit Nachteilen verbunden, da einerseits weitere, möglicherweise von dem Oszillator gespeiste Komponenten kein Signal mehr erhalten und da es zu erheblichen Verzögerungen bei erneuter Aktivierung des Oszillators aufgrund der hiermit verbundenen Einschwingphase kommt.

Daher ist es eine Aufgabe der vorliegenden Erfindung, eine Frequenzgeneratoranordnung sowie einen Radar-Transmitter, einen Radar-Receiver oder eine Verwendung anzugeben, mit der die Steuerung einer Ausgangsleistung bis hin zur Deaktivierung bei verbesserter Isolationswirkung und verzögerungsarmer Steuerbarkeit erreicht werden kann.

Diese Aufgabe wird gelöst durch eine Frequenzgeneratoranordnung gemäß Anspruch 1, durch einen Radar-Transmitter gemäß Anspruch 9, durch einen Radar-Receiver gemäß Anspruch 10 oder eine Verwendung gemäß Anspruch 12 und ein Verfahren gemäß Anspruch 13. Vorteilhafte Weiterbildungen sind Gegenstand der Unteransprüche.

Eine vorschlagsgemäße Frequenzgeneratoranordnung weist einen Oszillator zur Erzeugung eines Oszillator-Signals mit einer Oszillator-Frequenz und einen Oszillator-Ausgang zur Abgabe des Oszillator-Signals auf. Ferner weist die Frequenzgeneratoranordnung einen mit dem Oszillator-Ausgang gekoppelten Frequenzvervielfacher zur Erzeugung eines Ausgangssignals der Frequenzgeneratoranordnung mit einer Vervielfacher-Frequenz auf, die einem Vielfachen der Oszillator-Frequenz entspricht.

Ein Frequenzvervielfacher im Sinne der vorliegenden Erfindung ist eine elektronische Schaltung, die ausgehend von einem Eingangssignal ein Ausgangssignal erzeugt, das ein Vielfaches der Frequenz der Frequenz des Eingangssignals aufweist.

Der Oszillator ist, bevorzugt unmittelbar, mit dem Frequenzvervielfacher gekoppelt, sodass das Oszillator-Signal, das insbesondere zumindest im Wesentlichen sinusförmig und/oder differenziell vorliegen kann, am Eingang des Frequenzvervielfachers anliegt, wodurch der Frequenzvervielfacher das Ausgangssignal erzeugt, welches ein Vielfaches der Oszillator-Frequenz aufweist.

Das Ausgangssignal kann grundsätzlich auch spektrale Anteile bei unterschiedlichen Frequenzen aufweisen. Als Frequenz des Ausgangssignals wird in diesem Zusammenhang diejenige Frequenz bezeichnet, die das Ausgangssignal prägt, die die höchste spektrale Leistungsdichte aufweist und/oder die im Folgenden verwendet bzw. nicht unterdrückt wird.

Der Frequenzvervielfacher weist einen Frequenzvervielfacher-Kern auf, der für die Frequenzvervielfachung unmittelbar ursächlich ist.

Bei dem Frequenzvervielfacher-Kern handelt es sich vorzugsweise um eine elektronische Schaltung, die innerhalb des Frequenzvervielfachers unmittelbar für die Funktion der Frequenzvervielfachung ursächlich ist.

Der Frequenzvervielfacher-Kern wiederum weist eine Energieversorgung auf. Die Energieversorgung ist vorzugsweise eine Komponente, ein Bauteil, ein Bauelement bzw. eine Schaltung zur Vorgabe oder Steuerung einer Stromaufnahme des Frequenzvervielfacher-Kerns.

Erfindungsgemäß weist die Frequenzgeneratoranordnung einen Steuereingang zur Steuerung der Energieversorgung des Frequenzvervielfacher-Kerns auf, wodurch eine Ausgangsleistung des Ausgangssignals durch die Steuerung der Energieversorgung des Frequenzvervielfacher-Kerns einstellbar ist oder eingestellt wird.

Insbesondere ist es erfindungsgemäß, über den Steuereingang die Energieversorgung des Frequenzvervielfacher-Kerns zu steuern bzw. zu verändern, während der Oszillator das Oszillator-Signal mit der Oszillator-Frequenz am Oszillator-Ausgang abgibt, wodurch eine Ausgangsleistung des Ausgangssignals gesteuert bzw. verändert wird, während der Oszillator das Oszillator-Signal mit der Oszillator-Frequenz am Oszillator-Ausgang abgibt.

Entsprechend ist die Ausgangsleistung des Ausgangssignals durch die Steuerung der Energieversorgung des Frequenzvervielfacher-Kerns erfindungsgemäß einstellbar / wird eingestellt bzw. ist veränderbar / wird verändert, während der Oszillator das Oszillator-Signal mit der Oszillator-Frequenz am Oszillator-Ausgang abgibt.

Es ist erfindungsgemäß vorgesehen, dass der Frequenzvervielfacher-Kern durch Reduktion oder Deaktivierung seiner Stromversorgung mittels der Energieversorgung einstellbar ausgebildet ist bzw. eingestellt wird, um eine Ausgangsleistung bzw. Ausgangsamplitude des Ausgangssignals, im Folgenden Vervielfacher-Ausgangsleistung genannt, zu variieren.

Insbesondere wird die Vervielfacher-Ausgangsleistung während der Erzeugung des Ausgangssignals verändert, insbesondere reduziert und/oder geregelt bzw. ist die Vervielfacher-Ausgangsleistung während der Erzeugung des Ausgangssignals veränderbar, insbesondere reduzierbar und/oder regelbar. Hierzu weist die Frequenzgeneratoranordnung eine Leistungssteuerung auf.

Mit der Leistungssteuerung kann die Vervielfacher-Ausgangsleistung während (im zeitlichen Verlauf) der Erzeugung des Ausgangssignals verändert, insbesondere reduziert und/oder geregelt werden bzw. die Frequenzgeneratoranordnung bzw. Leistungssteuerung kann hierzu ausgebildet sein.

Erfindungsgemäß kann die Leistungssteuerung die Energieversorgung des Frequenzvervielfacher-Kerns ändern, während der Oszillator das Oszillator-Signal mit der Oszillator-Frequenz am Oszillator-Ausgang abgibt, mit dem der Frequenzvervielfacher gekoppelt ist. Hierzu kann die Leistungssteuerung ein entsprechendes Steuersignal an dem Steuereingang erzeugen.

Es hat sich in überraschender Weise herausgestellt, dass die Verwendung des Frequenzvervielfachers zur Erzeugung einer Dämpfung, insbesondere zum Abschalten des Ausgangssignals, eine besonders effektive Steuerung und hohe Isolationswirkung ermöglicht. So kann durch Steuerung der Energieversorgung des Frequenzvervielfacher-Kerns erreicht werden, dass das Ausgangssignal bei dem Vielfachen der Oszillator-Frequenz nicht erzeugt wird. Ein etwaiges Durchsprechen des Oszillator-Signals wird regelmäßig durch die Schaltungsanordnung, die den Frequenzvervielfacher realisiert, stark gedämpft, jedenfalls wenn der Frequenzvervielfacher nicht oder nur eingeschränkt mit Strom versorgt wird, was durch die Steuerung der Energieversorgung möglich ist.

Darüber hinaus sind Komponenten wie Lasten des Frequenzvervielfachers und/oder eine etwaige Antenne bevorzugt auf die Vervielfacher-Frequenz ausgelegt, sodass diese Komponenten eine weitergehende Unterdrückung des Oszillator-Signals ermöglichen. Daher hat es sich gezeigt, dass der Einsatz eines Frequenzvervielfachers mit Steuerung seiner Energieversorgung sehr effektiv zur Steuerung der Leistung des Ausgangssignals einschließlich der Deaktivierung des Ausgangssignals eingesetzt werden kann.

Der Frequenzvervielfacher kann ein Hochpassfilter aufweisen oder das Hochpassfilter kann dem Frequenzvervielfacher zugeordnet sein. Das Hochpassfilter kann dazu ausgebildet sein, das Oszillator-Signal bzw. durch den Oszillator erzeugbare Frequenzen zu dämpfen, während die Vervielfacher-Frequenz zumindest im Wesentlichen nicht oder geringer gedämpft wird, als das Oszillator-Signal bzw. durch den Oszillator erzeugbare Frequenzen. Das Hochpassfilter kann eine 3-dB-Eckfrequenz aufweisen, die bevorzugt zwischen einer Frequenz des Oszillator-Signals bzw. der durch den Oszillator erzeugbaren Frequenzen und der Vervielfacher-Frequenz liegt.

Besonders bevorzugt ist das Hochpassfilter durch einen Hohlleiter oder ein Hohlleiterfunktionselement gebildet. Hohlleiter haben die Eigenschaft, Frequenzen unterhalb der Cut-Off-Frequenz zu dämpfen. Die Cut-Off-Frequenz eines Hohlleiters, der den Hochpassfilter bildet oder bilden kann, liegt daher bevorzugt zwischen einer Frequenz des Oszillator-Signals bzw. der durch den Oszillator erzeugbaren Frequenzen und der Vervielfacher-Frequenz.

Der Frequenzvervielfacher-Kern kann durch eine elektrische Schaltung gebildet sein, die bei Ansteuerung eines Eingangs dieser Schaltung mit dem Oszillator-Signal bei der Oszillator-Frequenz das Ausgangssignal bei einem Vielfachen der Oszillator-Frequenz erzeugt. Insbesondere handelt es sich um einen Frequenzverdoppler oder Frequenzvervierfacher.

Besonders bevorzugt weist die Frequenzgeneratoranordnung einen einstufigen Frequenzvervielfacher, insbesondere Frequenzverdoppler, also einen Frequenzvervielfacher mit genau einem Frequenzvervielfacher-Kern auf. In diesem Fall ist der Oszillator-Ausgang direkt mit dem Vervielfacher-Eingang des Frequenzvervielfachers gekoppelt und der Frequenzvervielfacher bildet direkt das Ausgangssignal. Mehrere Teil-Vervielfachungen können hierbei auf mehrere, insbesondere kaskadierte, Teil-Frequenzvervielfacher-Kerne aufgeteilt sein, wobei es ausreichen kann, dass einer der Teil-Frequenzvervielfacher-Kerne wie im Folgenden beschrieben steuerbar ist oder gesteuert wird.

Alternativ kann der Frequenzvervielfacher auch mehrstufig gebildet sein, also mehrere Frequenzvervielfacher-Kerne, insbesondere eine Kaskade hintereinander geschalteter Frequenzvervielfacher-Kerne aufweisen. In diesem Fall ist es ausreichend, wenn die im Folgenden anhand eines Frequenzvervielfacher-Kerns beschriebenen Eigenschaften durch mindestens einen steuerbaren der mehreren Frequenzvervielfacher-Kerne realisiert sind.

Ein steuerbarer Frequenzvervielfacher-Kern im Sinne der vorliegenden Erfindung ist erfindungsgemäß ein Frequenzvervielfacher-Kern mit einer Energieversorgung, über die eine (Vervielfacher-) Ausgangsleistung des durch ihn gebildeten Ausgangssignals steuerbar ist bzw. gesteuert wird.

Dieser eine steuerbare der Frequenzvervielfacher-Kerne ist dann direkt oder indirekt, insbesondere über einen oder mehrere weitere Frequenzvervielfacher-Kerne, mit dem Oszillator-Ausgang gekoppelt. Wenn der eine steuerbare der Frequenzvervielfacher-Kerne indirekt mit dem Oszillator-Ausgang gekoppelt und/oder mit einem Oszillator-Signal einer bereits (vor-)vervielfachten Oszillator-Frequenz angesteuert ist, liegt an einem Eingang des einen steuerbaren der Frequenzvervielfacher-Kerne ein durch den oder die vorangehenden Frequenzvervielfacher-Kerne vorverarbeitetes Oszillator-Signal, das eine bereits vor-vervielfachte Oszillator-Frequenz aufweisen kann. Hierbei liegt das Oszillator-Signal also indirekt vorverarbeitet, insbesondere mit vor-vervielfachter Oszillator-Frequenz an. Aus dieser bereits vor-vervielfachten Oszillator-Frequenz erzeugt dann der eine steuerbare der Frequenzvervielfacher-Kerne durch Frequenzvervielfachung das Ausgangssignal mit einer entsprechend vervielfachten Oszillator-Frequenz.

Der im Folgenden näher erläuterte, steuerbare Frequenzvervielfacher-Kern ist bei einem Frequenzvervielfacher mit mehreren Frequenzvervielfacher-Kernen vorzugsweise derjenige, der das Ausgangssignal direkt bildet, also vorzugsweise das letzte Glied in einer Kaskade von Frequenzvervielfacher-Kernen. Alternativ oder zusätzlich kann der steuerbare Frequenzvervielfacher-Kern das Ausgangssignal indirekt nach Weiterverarbeitung durch einen oder mehrere nachfolgende Frequenzvervielfacher-Kerne bilden.

Die Frequenzgeneratoranordnung weist erfindungsgemäß eine Leistungssteuerung auf, die dazu ausgebildet ist, durch Steuerung der Energieversorgung des Frequenzvervielfacher-Kerns innerhalb des Ausgangssignals in mindestens einem (zeitlichen) **In**tervall die Ausgangsleistung der Frequenzgeneratoranordnung zu reduzieren.

Mit anderen Worten ist die Frequenzgeneratoranordnung dazu ausgebildet bzw. wird so gesteuert, das Ausgangssignal zeitweise zu dämpfen bzw. zu deaktivieren. Auf diese Weise kann beispielsweise die Abstrahlung von Signalen über eine mit der Frequenzgeneratoranordnung koppelbare Antenne gesteuert werden, insbesondere zur Vermeidung von Interferenzen.

Der Oszillator, der mit dem Frequenzvervielfacher (unmittelbar oder mittelbar) gekoppelt ist, ist hiervon vorzugsweise unabhängig bzw. erzeugt weiterhin das Oszillator-Signal bei der Oszillator-Frequenz.

Die Leistungssteuerung ist vorzugsweise dazu ausgebildet oder wird so betrieben, zur Vermeidung einer Kollision oder Interferenz mit einem externen Signal die Ausgangsleistung der Frequenzgeneratoranordnung zumindest in einem zeitlichen **In**tervall und/oder in mindestens einem Frequenzbereich so zu reduzieren, dass eine Kollision bzw. Interferenz mit dem externen Signal vermieden wird.

In diesem Zusammenhang kann die Frequenzgeneratoranordnung eine Kollisionserkennungseinrichtung zur Erkennung von Kollision bzw. Interferenzen aufweisen oder eine solche kann ihr zugeordnet sein, wobei diese vorzugsweise über den Steuereingang mittels der Steuerung der Energieversorgung die Ausgangsleistung des Ausgangssignals automatisch anpasst, insbesondere das Ausgangssignal automatisch deaktiviert, wenn eine (potentielle) Kollision bzw. Interferenz detektiert wird.

Die Frequenzgeneratoranordnung weist vorzugsweise eine Oszillator-Steuerung auf, die dazu ausgebildet ist bzw. betrieben wird, durch Steuerung des Oszillators Radarsignale, insbesondere FMCW-Signale, zu erzeugen.

Der Oszillator ist vorzugsweise ein verstimmbarer Oszillator, bei dem die Oszillator-Frequenz variierbar, insbesondere einstellbar ist. Ganz besonders bevorzugt handelt es sich bei dem Oszillator um einen spannungsgesteuerten Oszillator, auch VCO genannt. Alternativ kann es sich jedoch auch um einen stromgesteuerten Oszillator, auch CCO genannt, oder einen auf sonstige Weise in Hinblick auf die Oszillator-Frequenz steuerbaren Oszillator handeln.

Zur Erzeugung von Radarsignalen, insbesondere FMCW-Signalen, kann der Oszillator gesteuert werden, eine sogenannte Frequenzrampe zu erzeugen. Hierbei wird die Oszillator-Frequenz mit einem bevorzugt zumindest im Wesentlichen konstanten Frequenz-Gradienten geändert, sodass in einem Diagramm der Oszillator-Frequenz über der Zeit eine vorzugsweise zumindest im Wesentlichen lineare Rampe erzeugt wird. Grundsätzlich können jedoch auch andersartige Radarsignale durch den Oszillator erzeugt werden bzw. der Oszillator kann hierzu gesteuert werden. Insbesondere ist also vorgesehen, dass durch den Oszillator eine Frequenzrampe als Oszillator-Signal erzeugt wird und entsprechend das Ausgangssignal des Frequenzvervielfachers ebenfalls eine entsprechende Rampenform bei einer vervielfachten Frequenz aufweist.

Es ist weiter bevorzugt, dass die Oszillatorsteuerung oder das durch den Oszillator erzeugte Oszillator-Signal in Form eines Radarsignals nicht beeinflusst wird, während das Ausgangssignal der Frequenzgeneratoranordnung in einem (zeitlichen) Intervall des durch den Frequenzvervielfacher in seiner Frequenz vervielfachten, vom Oszillator stammenden Radarsignals in seiner Ausgangsleistung reduziert wird, insbesondere wobei die Ausgangsleistung zumindest im Wesentlichen vollständig reduziert bzw. abgeschaltet wird. Auf diese Weise lässt sich eine besonders effektive Interferenzvermeidung realisieren.

Weiter ist bevorzugt, dass außerhalb des (zeitlichen) Intervalls eine Signalform des Ausgangssignals der Signalform des Oszillator-Signals, jedoch bei einem Vielfachen der Oszillator-Frequenz, entspricht. Insbesondere ist bevorzugt, dass außerhalb des (zeitlichen) Intervalls eine Vervielfacher-Frequenz des Ausgangssignals dem Vielfachen der Oszillatorfrequenz entspricht. Alternativ oder zusätzlich ist bevorzugt, dass außerhalb des (zeitlichen) Intervalls ein Frequenz-Gradient des Ausgangssignals dem Frequenz-Gradienten des Oszillator-Signals entspricht. Alternativ oder zusätzlich ist bevorzugt, dass außerhalb (zeitlichen) Intervalls ein Frequenzverlauf dem Frequenzverlauf des Oszillator-Signals bei einer vielfachen Frequenz der Oszillator-Frequenz entspricht. Schließlich ist bevorzugt, dass eine Oszillator-Ausgangsleistung dauerhaft und/oder die Vervielfacher-Ausgangsleistung außerhalb des (zeitlichen) Intervalls zumindest im Wesentlichen konstant ist.

Insbesondere ist also vorgesehen, dass durch den Oszillator eine Frequenzrampe als Oszillator-Signal erzeugt wird und entsprechend das Ausgangssignal des Frequenzvervielfachers ebenfalls eine entsprechende Rampenform bei einer vervielfachten Frequenz aufweist, abgesehen von dem (zeitlichen) Intervall, in dem das Ausgangssignal gedämpft bzw. deaktiviert sein kann und hier nicht zwingend eine Frequenz aufweist. Die zeitliche Abhängigkeit der Frequenz bleibt also vorzugsweise über die gesamte Rampe konstant, während die Amplitude bzw. Ausgangsleistung des Ausgangssignals im (zeitlichen) Intervall gedämpft bzw. zumindest im Wesentlichen deaktiviert ist.

Mit anderen Worten ist bevorzugt, dass das Ausgangssignal der Frequenzgeneratoranordnung - bevorzugt beidseitig - angrenzend an das Intervall eine zumindest im Wesentlichen konstante Frequenzänderungsrate bzw. einen zumindest im Wesentlichen konstanten Frequenz-Gradienten und eine bevorzugt konstante Amplitude aufweist, sodass eine Interpolation eines Frequenzverlaufs des Ausgangssignals über das Intervall hinweg zu einer (vollständigen) Rampenform mit einem stetigen, insbesondere linearen, Verlauf mit zumindest im Wesentlichen konstanter Frequenzänderungsrate bzw. einem zumindest im Wesentlichen konstanten Frequenz-Gradienten des Ausgangssignals, insbesondere einer FMCW-Radar-Rampe, führt.

Es hat sich in überraschender Weise gezeigt, dass ein Radar-System mit einer Funktion, bei der ein Teil der Rampe, ein Frequenzabschnitt bzw. ein zeitlicher Abschnitt in der genannten Art und Weise unterdrückt werden kann, sich besonders gut für eine Interferenzvermeidung eignet, während die verbleibenden Rampen-Teile für eine gute Leistungsfähigkeit des hiermit betriebenen Radar-Systems ausreichen kann.

Die Energieversorgungseinrichtung weist vorzugsweise eine steuerbare Stromquelle auf oder ist hierdurch gebildet. Die steuerbare Stromquelle ist vorzugsweise über den Steuereingang steuerbar. Besonders bevorzugt ist die steuerbare Stromquelle durch eine Stromspiegelschaltung realisiert, die mit dem Steuereingang gekoppelt ist.

Der Frequenzvervielfacher weist vorzugsweise einen elektronischen Filter auf. Ein elektronischer Filter im Sinne der vorliegenden Erfindung ist vorzugsweise eine Einrichtung, insbesondere gebildet durch ein oder mehrere elektronische Bauelemente, die zur frequenzselektiven Transmission und/oder Dämpfung ausgebildet ist. Insbesondere kann es sich hierbei um einen oder mehrere Schwingkreise und/oder Wellenleitungen, insbesondere Mikrostreifenleitungen, handeln.

Es ist also im Ergebnis bevorzugt, dass der Frequenzvervielfacher einen oder mehrere Schwingkreise und/oder Wellenleitungen als Last des Frequenzvervielfacher-Kerns aufweist, sodass die Oszillator-Frequenz im Ausgangssignal unterdrückt ist, bevorzugt jedoch nicht die durch den Frequenzvervielfacher vervielfachte Oszillator-Frequenz, die gegenüber der Oszillator-Frequenz verstärkt sein kann. Auf diese Weise kann eine Filterwirkung erzeugt werden, die die Isolationswirkung durch den die Energieversorgung aufweisenden Frequenzvervielfacher-Kern verbessert.

In einer bevorzugten Ausgestaltung weist der Frequenzvervielfacher, insbesondere der Frequenzvervielfacher-Kern, eine Gilbertzelle auf oder basiert auf einer Struktur, die einer Gilbertzelle ähnelt. Diese ist vorzugsweise derart mit dem Oszillator-Ausgang gekoppelt, dass das Oszillator-Signal den Frequenzvervielfacher eingangsseitig, bevorzugt differenziell ansteuert. Alternativ oder zusätzlich stellt der Frequenzvervielfacher-Kern mit der Gilbertzelle ein ausgangsseitig bevorzugt differenzielles Ausgangssignal der doppelten oder mehrfachen Oszillator-Frequenz zur Verfügung.

Ein weiterer, auch unabhängig realisierbarer Aspekt der vorliegenden Erfindung betrifft einen Radar-Transmitter, wobei der Radar-Transmitter eine Frequenzgeneratoranordnung nach einem der voranstehenden Aspekte aufweist und mit einer Radar-Antenne koppelbar oder gekoppelt ist, sodass das Ausgangssignal der Frequenzgeneratoranordnung über die Radar-Antenne transmittierbar bzw. abstrahlbar ist.

Ein weiterer, auch unabhängig realisierbarer Aspekt der vorliegenden Erfindung betrifft einen Radar-Receiver, wobei der Radar-Receiver eine Frequenzgeneratoranordnung der vorherigen Aspekte und mindestens einen Mischer aufweist.

Der Mischer ist zum Umsetzen einer Frequenz eines Empfangssignals ausgebildet, das mittels einer mit dem Mischer koppelbaren oder gekoppelten Radar-Antenne empfangbar ist.

Der Mischer ist mit dem Ausgang der Frequenzgeneratoranordnung gekoppelt, sodass der Mischer dazu eingerichtet ist, dass das Empfangssignal durch den Mischer mittels des Ausgangssignals der Frequenzgeneratoranordnung als Lokaloszillatorsignal in seiner Frequenz umsetzbar ist. Der Mischer ist also im Ergebnis dazu eingerichtet, das Empfangssignal mit dem Ausgangssignal der Frequenzgeneratoreinrichtung zu mischen, und zwar unter Verwendung des Ausgangssignals der Frequenzgeneratoranordnung als Lokaloszillatorsignal des Mischers, sodass das Empfangssignal um die Frequenz des Ausgangssignals verschoben wird.

Hierbei ist der Mischer vorzugsweise dazu ausgebildet, dass die Frequenzverschiebung zu niedrigeren Frequenzen hin erfolgt. Wenn der Mischer gleichzeitig eine Frequenzverschiebung zu niedrigeren und höheren Frequenzen bewirkt, kann der Anteil bei den höheren Frequenzen unterdrückt oder gedämpft werden. Hier sind jedoch auch andere Lösungen möglich, insbesondere wenn es sich um einen Mischer handelt, der nicht, wie hier bevorzugt, Teil eines Radar-Receivers bildet.

Vorzugsweise ist der Radar-Receiver dazu ausgebildet, den Mischer mit einem Lokaloszillatorsignal in Form des Oszillator-Signals zu versorgen, während das Ausgangssignal des Frequenzvervielfachers bzw. eines (anderen) mit demselben Oszillator gekoppelten Frequenzvervielfachers mittels der Energieversorgung des Frequenzvervielfachers in seiner Leistung reduziert wird, insbesondere besonders im Wesentlichen abgeschaltet wird oder ist.

Es ist also grundsätzlich möglich, insbesondere auch bei dem vorschlagsgemäßen Radar-Receiver vorgesehen, dass der Oszillator unabhängig von der Energieversorgung des Frequenzvervielfachers ist, also bei Reduktion oder Deaktivierung des Ausgangssignals des Frequenzvervielfachers die Funktion des Oszillators zur Bildung des Oszillator-Signals unverändert ist.

Ein weiterer Aspekt der vorliegenden Erfindung betrifft ein Radarsystem mit einem Radar-Transceiver aufweisend einen Radar-Transmitter und einen Radar-Receiver nach den vorherigen Aspekten, wobei der Radar-Transmitter und der Radar-Receiver sich vorzugsweise eine gemeinsame Frequenzgeneratoranordnung oder jedenfalls den Oszillator nach einem der vorherigen Aspekte teilen.

Der Vervielfacher-Ausgang ist also insbesondere zum Senden mit einer Antenne gekoppelt oder koppelbar und gleichzeitig ist ein Vervielfacher-Ausgang als Lokaloszillatorsignal mit dem Mischer des Radar-Receivers gekoppelt. Hierzu kann dasselbe Ausgangssignals verwendet werden.

Alternativ oder zusätzlich sind mehrere Frequenzvervielfacher oder jedenfalls Frequenzvervielfacher-Kerne vorgesehen, die jeweils mit demselben Oszillator-Signal oder demselben vorvervielfachten Oszillator-Signal angesteuert werden bzw. mit demselben Oszillator-Ausgang oder demselben vorgeschalteten Frequenzvervielfacher-Kern gekoppelt ist/sind. Entsprechend können mehrere gleiche oder zueinander korrespondierende Ausgangssignale erzeugt werden, die getrennt voneinander über die Energieversorgung des (jeweiligen) Frequenzvervielfacher-Kerns steuerbar sein können.

Entsprechend kann das Ausgangssignal mittels der Antenne transmittierbar/abstrahlbar sein, und/oder es kann - vorzugsweise gleichzeitig - mit derselben oder einer anderen Antenne ein Empfangssignal empfangbar sein, wobei der Radar-Receiver mit der Radar-Antenne derart gekoppelt oder koppelbar ist, dass das Empfangssignal mit dem Mischer des Radar-Receivers (in seiner Frequenz) umsetzbar ist, besonders bevorzugt um die Frequenz des Ausgangssignals der Frequenzgeneratoranordnung.

Die Leistungssteuerung ist dazu ausgebildet, durch Steuerung der Energieversorgung des Frequenzvervielfacher-Kerns die Ausgangsleistung der Frequenzgeneratoranordnung in einer Anlaufphase und/oder in einer Abschaltphase der Frequenzgeneratoranordnung, des Oszillators und/oder einer dem Oszillator zugeordneten Regelung zu reduzieren.

In der Anlaufphase und/oder in einer Abschaltphase können Störsignale wie Signalanteile in unzulässigen Frequenzbereichen entstehen. In vorteilhafter Weise ist es mit der vorschlagsgemäßen Frequenzgeneratoranordnung möglich, derartige Störsignale bzw. ungewünschte Signalanteile zu unterdrücken, indem diese zwar vom Oszillator erzeugt, durch den Frequenzvervielfacher jedoch in ihrer Leistung reduziert bzw. unterdrückt werden.

Die Frequenzgeneratoranordnung weist erfindungsgemäß einen Regelkreis auf, mit dem die Ausgangsleistung des Ausgangssignals durch die Steuerung der Energieversorgung des Frequenzvervielfacher-Kerns auf eine Führungsgröße regelbar ist.

In vorteilhafter Weise kann die Ausgangsleistung des Ausgangssignals durch die Steuerung der Energieversorgung des Frequenzvervielfacher-Kerns auf einen über die Vervielfacher-Frequenz, Oszillator-Frequenz und/oder Zeit vorgegebenen festen Wert oder vorgegebenen Verlauf geregelt werden.

Die Regelung der Ausgangsleistung ermöglicht es vorzugsweise, die Ausgangsleistung über unterschiedliche Vervielfacher-Frequenzen bzw. Oszillator-Frequenzen zu regeln, insbesondere konstant zu halten.

So ist es möglich, mit dem Oszillator ein Radarsignal, vorzugsweise ein FMCW-Signal, insbesondere eine Frequenzrampe 23 vorzugeben, während die Ausgangsleistung des Ausgangssignals durch die Steuerung der Energieversorgung des Frequenzvervielfacher-Kerns, insbesondere auf einen konstanten Wert, regelbar ist oder geregelt wird. Hierdurch kann eine Linearisierung erfolgen, die vorteilhaft ist, insbesondere bei Radar-Systemen, da durch eine derartige Linearisierung in diesem Zusammenhang die Präzision und Zuverlässigkeit verbessert werden können.

In einem weiteren, auch unabhängig realisierbaren Aspekt betrifft die vorliegende Erfindung die Verwendung eines Frequenzvervielfachers einer Frequenzgeneratoranordnung aufweisend einen Oszillator, der ausgangsseitig mit einem Eingang des Frequenzvervielfachers gekoppelt ist, zur Steuerung einer Ausgangsleistung eines Ausgangssignals der Frequenzgeneratoranordnung.

Die Steuerung der Ausgangsleistung durch Variation des Arbeitspunkts des Frequenzvervielfachers, insbesondere anstatt des Oszillators zu deaktivieren oder sonstige (einstellbare) Dämpfungsglieder, Schalter oder dergleichen einzusetzen, hat sich als besonders effektiv zur Erreichung guter Isolationswerte gezeigt. Weitere Aspekte, Vorteile und Eigenschaften der vorliegenden Erfindung ergeben sich aus den Ansprüchen und aus der nachfolgenden Beschreibung bevorzugter Ausführungsbeispiele anhand der Zeichnung.

Es zeigt:
- Fig. 1: eine schematische Ansicht eines Radar-Transceivers;
- Fig. 2: ein vereinfachtes Schaltbild eines erfindungsgemäßen Frequenzvervielfachers;
- Fig. 3: Diagramme des Oszillator-Signals; und
- Fig. 4: Diagramme des Ausgangssignals.

In den Figuren werden für gleiche oder ähnliche Komponenten dieselben Bezugszeichen verwendet, wobei entsprechend dieselben oder ähnliche Eigenschaften und Vorteile erreicht werden können, auch wenn von einer wiederholten Beschreibung abgesehen wird.

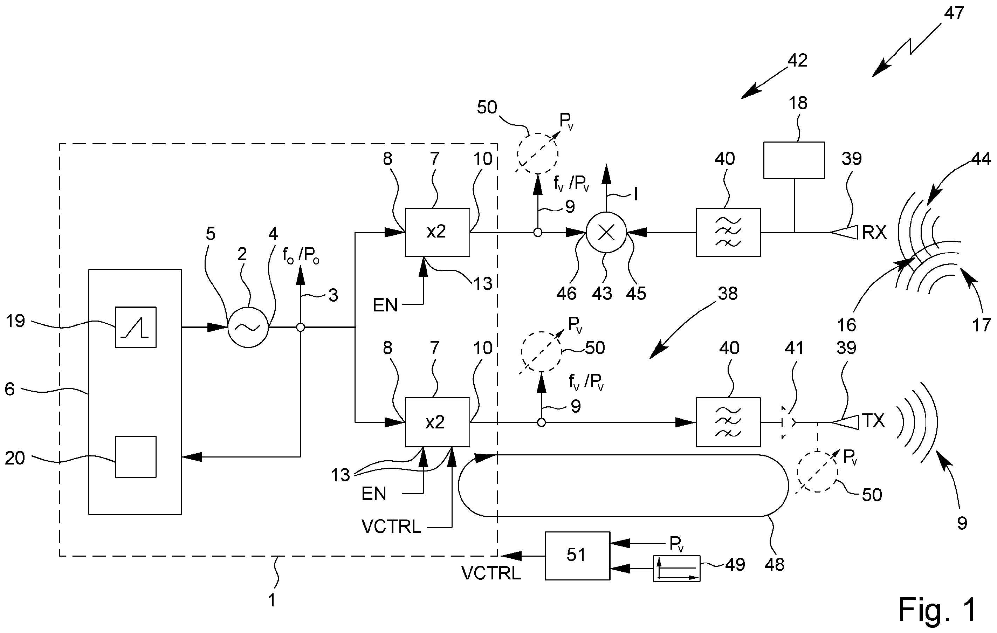

Fig. 1 zeigt eine schematische Ansicht eines Radar-Transceivers mit einer vorschlagsgemäßen Frequenzgeneratoranordnung 1 mit einem Oszillator 2 zur Erzeugung eines Oszillator-Signals 3. Das Oszillator-Signal 3 wird an einem Oszillator-Ausgang 4 ausgegeben.

Der Oszillator 2 kann über einen Oszillator-Steuereingang 5, bevorzugt in Bezug auf seine Oszillator-Frequenz fo einstellbar sein. Im Darstellungsbeispiel wird dies durch eine Rückkopplung bzw. Regelung mittels eines Phasenregelkreises (PLL) 6 erreicht, der den Oszillator 2 über den Oszillator-Steuereingang 5 auf eine bestimmte Oszillator-Frequenz fo bzw. einen bestimmten Frequenzverlauf der Oszillator-Frequenz fo regelt.

Die vorschlagsgemäße Frequenzgeneratoranordnung 1 weist weiter mindestens einen mit dem Oszillator-Ausgang 4 gekoppelten Frequenzvervielfacher 7 auf. Der Frequenzvervielfacher 7 ist dazu ausgebildet, ein Ausgangssignal 9 der Frequenzgeneratoranordnung 1 zu erzeugen. Das Ausgangssignal 9 weist vorzugsweise eine Vervielfacher-Frequenz fv auf, die einem Vielfachen der Oszillator-Frequenz fo entspricht.

Der Frequenzvervielfacher 7 ist mit einem Vervielfacher-Eingang 8 vorzugsweise mit dem Oszillator-Ausgang 4 gekoppelt, sodass das Oszillator-Signal 3 ein Eingangssignal des Frequenzvervielfachers 7 bildet. Weiter weist der Frequenzvervielfacher 7 vorzugsweise einen Vervielfacher-Ausgang 10 auf, über den das Ausgangssignal 9 abgegeben werden kann.

Der Frequenzvervielfacher 7 kann ein- oder mehrstufig aufgebaut sein. Im Darstellungsbeispiel handelt es sich vorzugsweise um einen einstufigen Frequenzvervielfacher 7 mit der Eigenschaft, dass ein am Vervielfacher-Eingang 8 anliegendes (Oszillator) Signal 3 durch den Frequenzvervielfacher 7 derart verarbeitet wird, dass das Ausgangssignal 9 im Vergleich hierzu die doppelte Frequenz als Vervielfacher Frequenz fv aufweist. Es handelt sich also insbesondere um einen Frequenzverdoppler. Grundsätzlich können aber auch Frequenzvervierfacher oder sonstige Frequenzvervielfacher 7 eingesetzt werden.

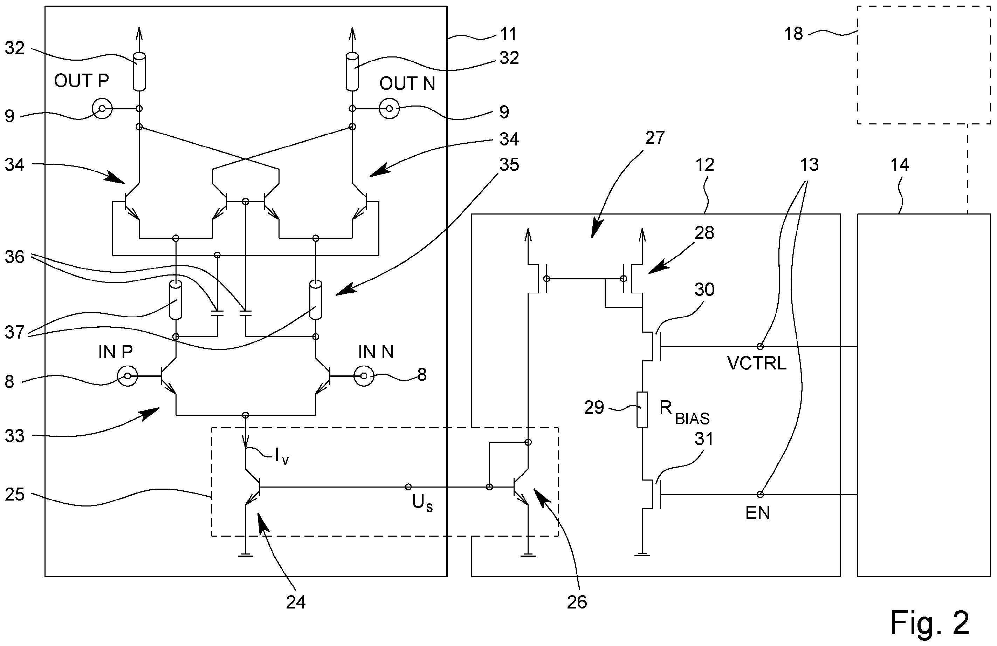

Fig. 2 zeigt ein vereinfachtes Schaltbild des erfindungsgemäßen Frequenzvervielfachers 7.

Der Frequenzvervielfacher 7 weist vorzugsweise einen Frequenzvervielfacher-Kern 11 auf. Dieser ist unmittelbar ursächlich für die Frequenzvervielfachung. Der Frequenzvervielfacher-Kern 11 wandelt also ein am Vervielfacher-Eingang 8 anliegendes Signal in das Ausgangssignal 9 um, wobei das Ausgangssignal 9 eine Vervielfacher-Frequenz fv aufweist, die einem Vielfachen der Frequenz eines am Vervielfacher-Eingang 8 anliegenden Signals entspricht, insbesondere also einem Vielfachen der Oszillator-Frequenz fo.

Der Frequenzvervielfacher-Kern 11 weist eine Energieversorgung 12 auf. Die Energieversorgung 12 ist dafür verantwortlich, dass der Frequenzvervielfacher-Kern 11 mit elektrischer Energie versorgt wird. Mit anderen Worten bestimmt oder beeinflusst die Energieversorgung 12 den Arbeitspunkt des Frequenzvervielfacher-Kerns 11. Insbesondere handelt es sich bei der Energieversorgung 12 um eine Stromquelle. Alternativ oder zusätzlich kann es sich jedoch auch um eine Spannungsquelle oder sonstige Einrichtung zur Steuerung der Leistungsaufnahme des Frequenzvervielfacher-Kerns 11 handeln.

Die Energieversorgung 12 ist vorzugsweise steuerbar. Hierzu kann die Frequenzgeneratoranordnung 1 ein Steuereingang 13 zur Steuerung der Energieversorgung 12 des Frequenzvervielfacher-Kerns 11 aufweisen. Entsprechend kann durch Steuerung der Energieversorgung 12 mittels des Steuereingangs 13 eine Vervielfacher-Ausgangsleistung Pv des Ausgangssignals 9 eingestellt werden.

Dies ermöglicht, insbesondere bei Frequenzen im Millimeterwellenbereich, bzw. zwischen 30 GHz und 300 GHz, eine besonders effektive Möglichkeit, das Ausgangssignal 9 mit einer entsprechend hohen Vervielfacher-Frequenz fv zu erzeugen und gleichzeitig eine steuerbare Vervielfacher Ausgangsleistung Pv des Ausgangssignals 9.

Es hat sich nämlich gezeigt, dass der Einsatz von Schaltern oder (variablen) Dämpfungsgliedern zur Variation der Ausgangsleistung von Frequenzgeneratoren aus dem Stand der Technik regelmäßig zu unerwünschten Effekten wie Dämpfungen durch den grundsätzlichen Einsatz entsprechender Baugruppen aufgrund parasitärer Effekte führt, sodass die hier vorgeschlagene Verwendung des Frequenzvervielfachers 7 zur Steuerung der Ausgangsleistung des Ausgangssignals 9 keine zusätzlichen Komponenten oder Baugruppen erfordert und gleichzeitig die mit Einsatz entsprechender Baugruppen verbundenen parasitären Verluste zu vermeiden hilft.

Die Frequenzgeneratoranordnung 1 weist eine mit dem Steuereingang 13 gekoppelte Leistungssteuerung 14 auf, wie in Fig. 2 schematisch angedeutet. Die Leistungssteuerung 14 ist dazu ausgebildet, durch Steuerung der Energieversorgung 12 des Frequenzvervielfacher-Kerns 11 die Vervielfacher-Ausgangsleistung Pv des Ausgangssignals 9 zu steuern.

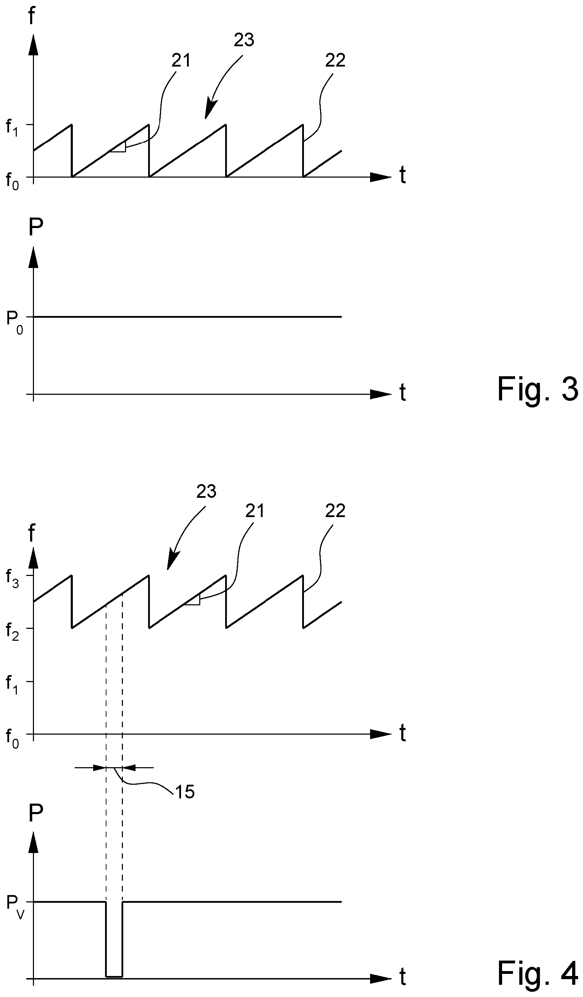

Fig. 3 und 4 zeigen in schematischen Diagrammen jeweils den Verlauf der Oszillator-Frequenz fo und der Oszillator-Ausgangleistung Po des Oszillator-Signals 3 und der Vervielfacher-Frequenz fv sowie der Vervielfacher-Ausgangsleistung Pv des Ausgangssignals 9. Auf die konkreten Kurvenverläufe wird zu einem späteren Zeitpunkt genauer eingegangen.

Wie exemplarisch in Fig. 4 zu erkennen, kann ein Intervall 15 vorgesehen sein, in dem die Vervielfacher-Ausgangsleistung Pv reduziert oder zumindest im Wesentlichen ausgeschaltet ist.

Im Darstellungsbeispiel handelt es sich um ein zeitliches Intervall, also einen zeitlichen (Teil-) Abschnitt des Ausgangssignals 9. Alternativ oder zusätzlich ist es jedoch noch möglich, dass die Vervielfacher-Ausgangsleistung Pv im Ausgangssignal 9 in einem bestimmten Frequenzbereich reduziert ist oder wird, insbesondere abgeschaltet.

Im Darstellungsbeispiel umfasst das zeitliche Intervall 15 einen Verlauf mit veränderlicher Vervielfacher-Frequenz fv, während dem die Vervielfacher-Ausgangsleistung Pv reduziert oder abgeschaltet wird, sodass im vorliegenden Ausführungsbeispiel sowohl in einem zeitlichen Intervall und entsprechend auch in einem bestimmten Frequenzbereich die Vervielfacher-Ausgangsleistung Pv reduziert, insbesondere abgeschaltet, wird oder ist. Hier sind jedoch auch andere Varianten möglich.

Insbesondere kann die Reduktion frequenzabhängig gesteuert werden, also die Reduktion bei vorgegebenen Frequenzen bzw. in vorgegebenen Frequenzspektren erfolgen. Alternativ oder zusätzlich ist es nicht zwingend, dass die Reduktion während eines Verlaufs mit veränderlicher Vervielfacher-Frequenz fv erfolgt. Auch die Vervielfacher-Ausgangsleistung Pv eines zum Zeitpunkt der Reduktion zumindest im Wesentlichen monofrequenten Signals kann reduziert werden.

Erreicht wird die Reduktion der Vervielfacher-Ausgangsleistung Pv bzw. das Abschalten dieser besonders bevorzugt durch Steuerung der Energieversorgung 12. Hierzu kann die Leistungssteuerung 14 über den Steuereingang 13 die Energieversorgung 12 derart beeinflussen, die Vervielfacher-Ausgangsleistung Pv reduziert oder aktiviert wird/ist.

Wie in Fig. 1 angedeutet, ist es in der Praxis möglich, dass eine Interferenz 16 mit einem externen Signal 17 vermieden werden soll. Hierzu kann ein Interferenzdetektor 18 vorgesehen sein, der ein entsprechendes externes Signal 17 bzw. eine Inter-ferenz 16 erkennen kann.

Die Leistungssteuerung 14 kann mit dem Interferenzdetektor 18 gekoppelt sein oder diesen aufweisen, sodass bei Detektion einer Interferenz 16 die Vervielfacher-Ausgangsleistung Pv, insbesondere in dem Intervall 15 bzw. entsprechenden Frequenzbereich reduziert oder abgeschaltet wird, sodass die Interferenz 16 bzw. eine durch Kollsion mögliche Interferenz 16 mit dem externen Signal 17 vermieden wird.

Die Vermeidung von Interferenzen 16 mittels der vorschlagsgemäßen Frequenzgeneratoranordung 1 hat sich als besonders effektiv erwiesen. Denn aufgrund der Verwendung des Frequenzvervielfachers 7 zur Steuerung der Vervielfacher-Ausgangsleistung Pv des Ausgangssignals 9 der Frequenzgeneratoranordnung 1 ist es möglich und bevorzugt, dass der Oszillator 2 unverändert bzw. ununterbrochen betrieben wird bzw. sein Oszillator-Signal 3 dauerhaft erzeugt wird, zumindest im Wesentlichen unabhängig davon, ob die Vervielfacher-Ausgangsleistung Pv ihrem Maximum bzw. Nennwert entspricht oder in der beschriebenen Weise reduziert oder deaktiviert ist.

Grundsätzlich ist die vorschlagsgemäße Frequenzgeneratoranordung 1 in unterschiedlichen Feldern der Technik, insbesondere Funktechnik einsetzbar. Dies schließt Kommunikationssysteme ein, bei denen das Ausgangssignal 9 als Referenz oder Trägersignal zur Aufmodulation von Informationen zwecks Funkdatenübertragung oder dergleichen verwendet werden kann. Besonders bevorzugt und hier mit dem vorliegenden Ausführungsbeispiel im Folgenden näher erläutert ist hingegen der Einsatz im Zusammenhang mit Radar-Systemen. Ganz besonders bevorzugt ist der Einsatz der vorschlagsgemäßen Frequenzgeneratoranordnung 1 in einem sogenannten FMCW-Radarsystem.

Bezugnehmend auf Fig. 1 kann die vorschlagsgemäße Frequenzgeneratoranordnung 1 eine Oszillator-Steuerung 19 aufweisen. Optional ist dieser eine Referenz 20 wie ein Quarz zugeordnet, um eine Stabilisierung zu ermöglichen. Im Darstellungsbeispiel bildet die Oszillator-Steuerung 19 einen Teil des Phasenregelkreises/PLL 6. Die Oszillator-Steuerung 19 kann jedoch auch separat hiervon realisiert sein. Die Oszillator-Steuerung 19 ist vorzugsweise dazu ausgebildet, den Oszillator 2 derart zu steuern, dass dieser ein Radarsignal erzeugt.

Wie in Fig. 3 im Verlauf der Oszillator-Frequenz fo des Oszillator-Signals 3 gezeigt, kann das Oszillator-Signal 3 frequenzmoduliert sein, wodurch ein Frequenz-Gradient 21 in einem als FMCW-Signal 22 realisierten Oszillator-Signal 3 ausgebildet sein kann. Im Ergebnis können hierdurch eine oder mehrere Frequenzrampen 23 erzeugt werden. Eine Frequenzrampe ist ein FMCW-Signal 22 bzw. Teil hiervon, bei dem die Oszillator-Frequenz fo zumindest im Wesentlichen kontinuierlich und/oder mit einem zumindest im Wesentlichen konstanten Frequenz-Gradienten 21 über die Zeit geändert wird. Entsprechende Eigenschaften weist auch das Ausgangssignal 9 auf, mit dem Unterschied, dass hier entsprechendes für die Vervielfacher-Frequenz fv als Vielfaches der Oszillator-Frequenz fo zutrifft. Ausgehend davon, dass das Oszillator-Signal 3 mittels des Frequenzvervielfachers 7 in seiner Oszillator-Frequenz fo vervielfacht wird, entspricht der Verlauf der Oszillator-Frequenz fo im Wesentlichen dem Verlauf der Vervielfacher-Frequenz fv abgesehen von der Frequenzvervielfachung.

Die Vervielfacher-Ausgangsleistung Pv des Ausgangssignals 9 kann entsprechend in dem FMCW-Signal 22 gesteuert werden, indem die Energieversorgung 12 des Frequenzvervielfachers 7 gesteuert wird.

Ganz besonders bevorzugt ist die Frequenzgeneratoranordnung 1 entsprechend dazu ausgebildet, in dem FMCW-Signal 10 oder einem sonstigen Radar-Signal als Ausgangssignal 9 die Vervielfacher-Ausgangsleistung Pv in dem zeitlichen Intervall 15 zu reduzieren, vorzugsweise zumindest im Wesentlichen abzuschalten. Dies erfordert keine Deaktivierung des Oszillators 2. Im Gegensatz kann die Oszillator-Steuerung 19 bzw. das durch den Oszillator 2 erzeugte FMCW-Signal 22 bzw. sonstige Radar-Signal von der Steuerung der Vervielfacher-Ausgangsleistung pc unabhängig sein. Im Darstellungsbeispel ist dies daran zu erkennen, dass in Fig. 3 das FMCW-Signal 22 als Oszillator-Signal 3 eine vorzugsweise zumindest im Wesentlichen unveränderliche bzw. konstante Oszillator-Ausgangsleistung Po aufweist, während die Vervielfacher-Ausgangsleistung Pv in dem Intervall 15 reduziert und insbesondere deaktiviert ist.

Es ist bevorzugt, dass sich das Intervall 15 nur über einen Teil eines Radar-Signals, insbesondere FMCW-Signals 22, und ganz bevorzugt nur über einen Teil oder Bruchteil einer Frequenzrampe 23 des FMCW-Signals 22 als Ausgangssignal 9 erstreckt. Beabsichtigt ist also, dass die Vervielfacher-Ausgangsleistung Pv des Ausgangssignals 9 nur in einem Teil des Verlaufs einer Frequenzrampe 23 in seiner Vervielfacher-Ausgangsleistung Pv reduziert bzw. abgeschaltet ist oder wird.

Beispielsweise kann vorgesehen sein, dass das (zeitliche) Intervall 15 sich über weniger als 50% vorzugsweise weniger als 40% und insbesondere weniger als 30% einer Frequenzrampe 23 erstreckt. Auf diese Weise wird eine Funktion eines zugeordneten Radar-Systems aufrechterhalten, während durch die beschriebenen Maßnahmen beispielsweise eine Interferenz 16 mit dem externen Signal 17 vermieden werden kann. Alternativ oder zusätzlich kann die Transmission des Radar-Signals, insbesondere FMCW-Signals 22, in einem (regulatorisch) geschützten Frequenzbereich, insbesondere mit einer Anforderung an eine deutlich reduzierte Sendeleistung erfolgen. Es ist somit möglich, mit einer ununterbrochenen Frequenzrampe 23 dennoch über die Frequenz variierende Randbedingungen einzuhalten. Hierdurch kann die Leistungsfähigkeit des Radar-Systems verbessert werden.

Außerhalb des Intervall 15 weist das Ausgangssignal 9 hingegen vorzugsweise einen zumindest im Wesentlichen stetigen Frequenzverlauf bzw. konstanten Frequenz-Gradienten 21 auf. Alternativ oder zusätzlich weist das Ausgangssignal 9 vorzugsweise eine Vervielfacher-Ausgangsleistung Pv auf, die außerhalb des Intervalls 15 zumindest im Wesentlichen gleichbleibend sein kann, während sie im Intervall 15 vorzugsweise reduziert oder deaktiviert ist. Entsprechend kann das Ausgangssignal 9 außerhalb des Intervalls ein FMCW-Signal 22 bilden, insbesondere eine oder mehrere Frequenzrampen 23.

Anhand von Fig. 2 wird im Folgenden ein möglicher Aufbau des bzw. eines der Frequenzvervielfacher(s) und seiner Energieversorgung 12 näher erläutert. Hierbei versteht es sich, dass es grundsätzlich auch andersartige Frequenzvervielfacher-Konzepte angewendet werden können, bei denen eine Vervielfacher-Ausgangsleistung Pv durch die Energieversorgung 12 beeinflussbar ist.

Im Darstellungsbeispiel gemäß Fig. 2 weist die Energieversorgung 12 eine Stromquelle 24 auf, die im Darstellungsbeispiel durch einen entsprechend geregelten Transistor, insbesondere einen Bipolar-Transistor und im konkreten Ausführungsbeispiel einen npn-Silizium-Bipolar-Transistor, realisiert ist.

Die Stromquelle 24 wird vorzugsweise derart gesteuert, dass sie dem Vervielfacher-Kern 11 im Übrigen zumindest im Wesentlichen konstanten Kernstrom Iv einprägt. Die Energieversorgung 12 bzw. Stromquelle 24 ist vorzugsweise dazu eingerichtet, diesen Kernstrom Iv zu steuern, insbesondere von einem Nennwert ausgehend zu reduzieren, um die Vervielfacher-Ausgangsleistung Pv zu steuern bzw. zu reduzieren.

Die Stromquelle 24 ist im Darstellungsbeispiel bevorzugt durch eine sogenannte Stromspiegelschaltung 25 realisiert. Bei einem Stromspiegel bzw. einer Stromspiegelschaltung 25 ist ein Steuereingang der Stromquelle 24, insbesondere des sie bildenden Transistors, insbesondere eine Basis des Transistors, gekoppelt mit dem Steuereingang eines Referenztransistors 26, vorliegend ebenfalls vorzugsweise die Basis dessen. Hierbei ist der Referenztransistor 26 vorzugsweise ein Transistor, der so verschaltet ist, dass an dem Steuereingang des die Stromquelle 24 bildenden Transistors eine Steuerspannung Us erzeugt wird, über die der Kernstrom Iv zumindest im Wesentlichen als gleich, vielfach oder korrespondierend zu einem durch den Referenztransistor 26 fließenden Strom bestimmt wird.

Wie im Darstellungsbeispiel gemäß Fig. 1 gezeigt, kann ein Frequenzvervielfachers 7 auch mehrere Steuereingänge 13 aufweisen. Ein Steuereingang 13 kann zum zumindest im Wesentlichen vollständigen Ausschalten der Ausgangsleistung Pv vorgesehen oder ausgebildet sein, in Fig. 1 mit einem "Enable"-Signal EN gekoppelt. Alternativ oder zusätzlich kann ein Steuereingang 13 mit einem "Kontroll"-Signal VCTRL gekoppelt sein, vorzugweise zum reduzieren bzw. steuern des Ausgangsleistung Pv, ohne sie zu auszuschalten. Eines der oder beide Signale können die Steuerspannung Us beeinflussen, steuern bzw. variieren. Die Steuerspannung Us kann zu einem oder beiden Signalen korrespondieren bzw. eines oder beide Signale bilden oder repräsentieren.

Bei einer Stromspiegelschaltung 25 ist hierzu üblicherweise der Steuereingang 13 - die Basis im vorliegenden Ausführungsbeispiel - gekoppelt mit einem weiteren Anschluss des Referenztransistors 26, bevorzugt mit dem Kollektoranschluss bzw. Drain-Anschluss im Fall von eingesetzten MOSFET-Transistoren, sodass sich derselbe durch den Referenztransistor 26 und die Stromquelle 24 fließende Strom ergibt. Durch unterschiedliche Dimensionierung des Referenztransistors 26 und des die Stromquelle 24 bildenden Transistors ist es möglich, dass ein Verhältnis zwischen dem Kernstrom Iv und dem durch den Referenztransistor 28 fließenden Strom eingestellt wird. Für nähere Details zur Auslegung wird auf die diesbezügliche übliche Fachliteratur verwiesen.

Im Darstellungsbeispiel ist der Kernstrom Iv vorzugsweise über den Steuereingang 13 steuerbar.

Zunächst kann grundsätzlich ein Widerstand 29 vorgesehen sein, der aufgrund der an ihm abfallenden Spannung einen Strom vorgibt, der über den Referenztransistor 26 die Steuerspannung Us und im Ergebnis den Kernstrom Iv vorgeben kann. Diesbezüglich gibt es jedoch auch andere Möglichkeiten der Realisierung.

Im Ausführungsbeispiel ist weiter vorgesehen, dass mindestens ein Steuereingang 13 vorgesehen ist, der mit einem Transistor 30, 31 gekoppelt ist, sodass eine am Steuereingang 13 anliegende Steuergröße, insbesondere Steuerspannung, den Kernstrom Iv bestimmt oder variiert. Im Darstellungsbeispiel wird der durch den Widerstand 29 fließende Strom beeinflusst und hierdurch unmittelbar oder mittelbar zur Veränderung des Kernstroms Iv bewirkt.

Ein Steuertransistor 30, 31 ist vorzugsweise ein Transistor, der zur Steuerung des Stroms verschaltet ist, der durch den Widerstand 29 fließt bzw. durch den Referenztransistor 26 und auf diese oder auf andere Weise im Ergebnis den Kernstrom Iv direkt oder indirekt steuert.

Grundsätzlich können auch mehrere Steuereingänge 13 vorgesehen sein. Im Ausführungsbeispiel gemäß Fig. 2 sind es zwei Steuereingänge 13, die jeweils mit dem Steuereingang (Basis/Gate) eines Steuertransistor 30, 31 gekoppelt sind. Von diesen Steuereingängen 13 kann ein Steuereingang 13 zur Reduktion der Vervielfacher-Ausgangsleistung Pv ausgebildet sein bzw. verwendet werden, während der andere Steuereingang 13 zum Ein- bzw. Ausschalten des Frequenzvervielfachers 7 bzw. seiner Vervielfacher-Ausgangsleistung Pv ausgebildet ist bzw. verwendet wird. Grundsätzlich können jedoch beide Funktionen auch mit nur einem Steuereingang 13 bzw. Steuertransistor 30, 31 realisiert werden.

Im Darstellungsbeispiel ergibt sich aus einem Pfad über den Steuertransistor 30, 31 und den Widerstand 29 ein Strom, der mit einem weiteren Stromspiegel 27 zu der Stromspiegelschaltung 25 gespiegelt wird, über den wiederrum der Kernstrom Iv eingeprägt wird. Diese Konstruktion mit zwei Stromspiegeln 25, 27 hat sich als gut geeignet erwiesen, auch bei begrenzten Versorgungsspannungen eine ausreichende Einstellbarkeit des Kernstroms Iv zu ermöglichen.

Im Darstellungsbeispiel ist der weitere Stromspiegel 27 mittels (P-Kanal) MOSFET-Transistoren realisiert. Der weitere Stromspiegel 27 weist vorzugsweise einen Referenztransistor 28 zur Erzeugung einer Referenzspannung auf, die zur Steuerung eines als Stromquelle verwendeten Transistors des weiteren Stromspiegels 27 mit diesem gekoppelt ist. Der zu spiegelnde Strom durch den Referenztransistor 28, der die Referenzspannung erzeugt, wird im Ausführungsbeispiel durch den Widerstand 29 und/oder die Steuertransistoren 30, 31 vorgegeben.

Grundsätzlich können jedoch auch alternative Stromspiegel 27 oder sonstige Strukturen verwendet werden, um die steuerbare Stromquelle, den die Stromquelle 24 bildenden Transistor bzw. allgemein die Energieversorgung 12 zu steuern.

Die Frequenzgeneratoranordnung 1 weist vorzugsweise einen oder mehrere Filter bzw. filternde elektronische Bauelemente auf. Hierbei handelt es sich im Sinne der vorliegenden Erfindung vorzugsweise um elektronische Bauelemente oder Strukturen, die eine von der Frequenz abhängige Dämpfung aufweisen, insbesondere also mit einem Hochpass-, Tiefpass- oder Bandpass verhalten.

Im Darstellungsbeispiel weist der Frequenzvervielfacher-Kern 11 als Lasten 32 Induktivitäten bzw. Wellenleitungen, insbesondere Streifenleitungen, auf, die eine von der Frequenz abhängige Impedanz aufweisen und entsprechend eine über der Frequenz abhängige Verstärkung bzw. Dämpfung bewirken, also eine Filterwirkung erzeugen. Alternativ oder zusätzlich können weitere Filter bzw. filternde Strukturen vorgesehen sein.

Die Lasten 32 bzw. sonstige Filter oder filternde Strukturen sind vorzugweise dazu ausgebildet, die Oszillator-Frequenz fo zu dämpfen bzw. diese mehr zu dämpfen als die Vervielfacher-Frequenz fv. Hierdurch kann eine verbesserte Isolationswirkung des Frequenzvervielfachers 7 erreicht werden. Hiermit ist insbesondere gemeint, dass durch die Oszillator-Frequenz fo dämpfende Wirkung ein Durchsprechen des am Vervielfacher-Eingang 8 anliegenden Oszillator-Signals 3 zum Vervielfacher-Ausgang 10 durch eine Filterwirkung vermindert wird. Dies kann dadurch bewirkt werden, dass die Last 32 bzw. deren Impedanz für die Oszillator-Frequenz fo niedriger ist als für die Vervielfacher-Frequenz fv, weshalb ein über etwaige parasitäre Effekte im Frequenzvervielfacher 7 bis zu der oder den Lasten 32 gelangende Anteile des Oszillator-Signals 3 an der oder den Lasten 32 nur einen geringe(re)n Spannungshub erzeugen, wodurch ihr Anteil am Ausgangssignal 9 verringert und bevorzugt vernachlässigt werden kann.

Der Frequenzgenerator-Kern 11 kann in seiner Grundstruktur einer Gilbert-Zelle ähneln, mit einer ersten Differenzstufe 33, die den Vervielfacher-Eingang 8 bildet, und die mit zwei weiteren Differenzstufen 34 gekoppelt ist, insbesondere über ein Koppelnetzwerk 35.

Durch dieses Koppelnetzwerk 35 sind die Steuereingange der zweiten Differenzstufen 34 kapazitiv mit Ausgängen der ersten Differenzstufe 33 gekoppelt und/oder es sind Induktivitäten bzw. Wellenleitungen 37 zwischen Ein- und Ausgängen (Sources, Kollektoren und Drains, Emitter) der ersten Differenzstufe 33 und den zweiten Differenzstufen 34 bevorzugt vorgesehen.

Die Kondensatoren 36 koppeln vorzugsweise Signale zwischen einem Knoten, an dem die jeweilige Induktivität bzw. Wellenleitung 37 mit dem jeweiligen Transistor der ersten Differenzstufe 33 verbunden ist, und dem jeweiligen Steuereingang, insbesondere der jeweiligen Basis, der die zweiten Differenzstufen 34 bildenden Transistoren. Die zweiten Differenzstufen 34 sind vorzugsweise kreuzgekoppelt mit den beiden Lasten 32 verbunden.

Die dem Frequenzvervielfacher 7 bzw. Frequenzvervielfacher-Kern 11 zugrunde liegende Struktur aus den Differenzstufen 33, 34 wird auch Gilbert-Zelle genannt. Entsprechend handelt es sich vorliegend vorzugsweise um ein Gilbert-Zellen-basierten Frequenzvervielfacher 7, insbesondere Frequenzverdoppler. Insbesondere handelt es sich um einen sogenannten Bootstrapped-Gilbert-Frequenzverdoppler, dessen Kernstrom Iv hier vorschlagsgemäß zwecks Steuerung seiner Vervielfacher-Ausgangsleistung Pv variiert wird. Grundsätzlich sind auch andere Verdoppler- oder Vervielfacher-Topologien geeignet, insbesondere solche, die mit einer gesteuerten Stromquelle 24 in entsprechender Weise gesteuert zu werden können.

Grundsätzlich ist es möglich, dass mehrere Frequenzvervielfacher 7 vorgesehen sind, von denen einer oder mehrere mit demselben Oszillator 2 gekoppelt sein können, um jeweils ein vorzugsweise gleiches, ähnliches und/oder zueinander korrespondierendes Ausgangssignal 9 bei einer vervielfachten Oszillator-Frequenz fo zu erzeugen.

Sofern, wie bevorzugt, der Vervielfachungsfaktor der jeweiligen Frequenzvervielfacher 7 derselbe ist, erzeugen diese grundsätzlich dasselbe Ausgangssignal 9. Es ist jedoch möglich und bevorzugt, dass entsprechende unterschiedliche Frequenzvervielfacher 7 voneinander getrennte Steuereingänge 13 aufweisen, sodass die unterschiedlichen Frequenzvervielfacher 7 getrennt voneinander gesteuert, insbesondere deren Ausgangssignale 9 unterschiedlich und getrennt voneinander gedämpft und/oder deaktiviert werden können.

Im Darstellungsbeispiel gemäß Fig. 1 ist der Oszillator 2 mit seinem Oszillator-Ausgang 4 mit den Vervielfacher-Eingängen 8 von zwei oder mehr Frequenzvervielfachern 7 gekoppelt. Die Frequenzvervielfacher 7 können über ihren jeweiligen Steuereingang 13 getrennt voneinander gesteuert, also insbesondere abgeschaltet, werden. Hierdurch kann beispielsweise mit einem der Frequenzvervielfacher 7 ein Empfang mit einem Frequenzvervielfacher 7 realisiert werden, während ein Senden durch Deaktivierung eines anderen der Frequenzvervielfacher 7 unterbunden wird.

Die vorliegende Erfindung betrifft in einem Aspekt einen Radar-Transmitter 38, also ein Sendepfad eines Radar-Systems, der die vorschlagsgemäße Frequenzgeneratoranordnung 1 aufweisen kann. Darüber hinaus weist der Radar-Transmitter 38 vorzugsweise eine Radar-Antenne 39 auf, über die das Ausgangssignal 9, bevorzugt mittels eines, (insbesondere Hochpass-) Filters 40 gefiltert, gesendet werden kann. Optional kann ein Leistungsverstärker 41 vorgesehen sein, der das Ausgangssignal 9 verstärkt zur Antenne 39 leitet.

Bei dem Radar-Transmitter 38 kann vorzugweise über den Steuereingang 13 des Frequenzvervielfachers 7, insbesondere wie zuvor beschrieben, die Vervielfacher-Ausgangsleistung Pv des Frequenzvervielfachers 7 reduziert oder deaktiviert werden, wodurch die Abstrahlleistung des Ausgangssignals 9 über die Antenne 30 gedämpft oder deaktiviert werden kann. Dies kann beispielsweise einer Interferenzvermeidung dienen, wie bereits zuvor erläutert.

In einem weiteren Aspekt betrifft die vorliegende Erfindung einen Radar-Receiver 42, also einen Empfangspfad eines Radar-Systems, der eine vorschlagsgemäße Frequenzgeneratoranordnung 1 aufweist. Auch hier ist bevorzugt, dass der Frequenzvervielfacher 7 über den Steuereingang 13 hinsichtlich der Vervielfacher-Ausgangsleistung Pv des Ausgangssignals 9 steuerbar bzw. die Vervielfacher-Ausgangsleistung Pv über den Steuereingang 13 deaktivierbar ist.

Der Radar-Receiver 42 weist vorzugsweise einen Frequenzumsetzer, insbesondere Mischer 43, auf, mit dem ein über eine bzw. die Radar-Antenne 39 empfangbares Empfangssignal 44 in seiner Frequenz umsetzbar ist. Ein empfangenes Empfangssignal 44 kann daher mit dem Mischer 43 so verarbeitet werden, dass die im Empfangssignal 44 enthalten Frequenzanteile verschoben werden.

Hierzu kann das Empfangssignal 44 über einen optionalen Filter 40, insbesondere Hochpassfilter, mit einem Signaleingang 45 des Mischers 43 gekoppelt sein. Darüber hinaus weist der Mischer 43 vorzugsweise einen Steuereingang 46 für ein sogenanntes Lokaloszillatorsignal auf, das vorliegend vorzugsweise durch das Ausgangssignal 9 gebildet ist. Der Mischer 43 hat vorzugsweise die Eigenschaft, die Frequenz von spektralen Anteilen des Empfangssignals 44 um die Lokaloszillatorfrequenz zu verschieben, vorliegend also um die Vervielfacher-Frequenz fv.

Das Filter 40, insbesondere des Sendepfads / Radar-Transmitters 38 und/oder des Empfangspfads / Radar-Receivers 42, kann einen Hohlleiter aufweisen. Insbesondere ist das Filter 40 durch einen Hohlleiter bzw. ein durch einen Hohlleiter erzeugtes Hohlleiterfunktionselement gebildet. Der Hohlleiter kann aufgrund seiner Cut-Off-Frequenz eine Hochpasscharakteristik aufweisen. Hierdurch kann der Hohlleiter die Funktion des Hochpassfilters erfüllen. Der Hohlleiter kann alternativ oder zusätzlich eine Kopplung der Frequenzgeneratoranordnung 1 direkt oder indirekt mit der Radar-Antenne 39 bzw. die Transmission des Ausgangssignals 9 und/oder des Empfangssignals 44 bewirken. Insofern kann der Hohlleiter eine Doppelfunktion der Filterung und der Signalleitung des Ausgangssignals 9 und/oder des Empfangssignals 44 bewirken.

Es ist bevorzugt, dass die Frequenzgeneratoranordnung 1 bzw. der mit dem Steuereingang 13 steuerbare Frequenzvervielfacher 7 des Radar-Receivers 42 derart steuerbar bzw. abschaltbar ist, um etwaige Einkopplungen des durch das Ausgangssignal 9 gebildete Lokaloszillatorsignals über den Mischer 3 in die Antenne 39 zu unterbinden. In vorteilhafter Weise kann hierdurch die Emission von etwaigen Störungen vermieden werden, wenn der Mischer 43 nicht betrieben wird.

In einem weiteren Aspekt betrifft die vorliegende Erfindung ein Radar-System 47 mit einem Radar-Transmitter 38 und einem Radar-Receiver 42, von denen zumindest einer die vorschlagsgemäße Frequenzgeneratoranordnung 1 aufweist. Darüber hinaus weist das Radar-System 47 vorzugsweise zumindest eine Radar-Antenne 39, insbesondere getrennte Radar-Antennen 39 für den Radar-Transmitter 38 und den Radar-Receiver 42, auf.

Die (jeweilige) Radar-Antenne 39 kann mit dem Radar-Transmitter 38 gekoppelt oder koppelbar sein, sodass das Ausgangssignal 9 mittels der Radar-Antenne 39 emittierbar ist, also gesendet werden kann. Alternativ oder zusätzlich ist die Radar-Antenne 39 mit dem Radar-Receiver 42 gekoppelt oder koppelbar, sodass ein mit der Radar-Antenne 39 empfangbares Empfangssignal 44 empfangen mit dem Mischer 43 hinsichtlich seiner Frequenz umsetzbar sein kann.

Grundsätzlich ist es möglich, dass das Radar-System 47 mehrere Radar-Receiver 42 und/oder Radar-Transmitter 38 aufweisen kann. Insofern kann es sich bei dem Radar-System 47 um ein MIMO-Radar-System 41 mit mehreren Eingängen und/oder Ausgängen handeln.

Weiter wurde die vorliegende Erfindung anhand eines, besonders bevorzugt Zweifach-, Frequenzvervielfachers 7 beschrieben, der (genau) einen Frequenzvervielfacher-Kern aufweist. Grundsätzlich ist es jedoch möglich und bevorzugt, dass der Frequenzvervielfacher 7 mehrere, insbesondere hintereinander geschaltete bzw. kaskadierte Frequenzvervielfacher-Stufen aufweist, die jeweils einen Frequenzvervielfacher-Kern 11 aufweisen. Hierbei kann jeder Frequenzvervielfacher-Kern 11 eine Vervielfachung um einen gewissen Faktor, beispielsweise, bewirken, sodass der Frequenzvervielfacher 7 aufgrund mehrerer Stufen einen entsprechenden Vervielfachungsfaktor realisieren kann, beispielsweise bei zwei kaskadierten Verdopplerstufen insgesamt eine Vervierfachung oder bei drei kaskadierten Verdopplerstufen insgesamt eine Verachtfachung der Oszillator-Frequenz fo zur Bildung des Ausgangssignal 9 mit der Vervielfacher-Frequenz fv.

In diesem Fall ist grundsätzlich ausreichend, wenn eine der Stufen, insbesondere die letzte Stufe bzw. nur einer der Frequenzvervielfacher-Kerne 11, insbesondere der an den Vervielfacher-Ausgang 10 unmittelbar angeschlossene Frequenzvervielfacher-Kern 11, die Energieversorgung 12 mit dem Steuereingang 13 aufweist. Alternativ oder zusätzlich können jedoch auch mehrere oder alle der Frequenzvervielfacher-Kerne 11 mit der Energieversorgung 12 und/oder dem Steuereingang 13 versehen sein.

Ein weiterer Aspekt der vorliegenden Erfindung betrifft die Verwendung des Frequenzvervielfachers 7 einer Frequenzgeneratoranordnung 1, die den Oszillator 2 aufweist, der ausgangsseitig mit dem Eingang 8 des Frequenzvervielfachers 7 gekoppelt ist, zur Steuerung der Vervielfacher-Ausgangsleistung Pv des Ausgangssignals 9 der Frequenzgeneratoranordnung 1.

In diesem Zusammenhang ist bevorzugt, dass die Vervielfacher-Ausgangsleistung im laufenden Betrieb gesteuert oder geregelt wird, insbesondere in Abhängigkeit von einem Betriebsmodus eines Radar-Systems 47 und/oder in Abhängigkeit von der Erkennung einer bestehenden oder drohenden Interferenz 16 bzw. Kollision mit externen Signalen 17 und/oder zum Ausblenden bestimmter Zeitintervalle 15 und/oder Frequenzbereiche, insbesondere solcher, die im unmittelbaren Anwendungsumfeld keine Verwendung finden können oder dürfen.

Der Oszillator 2 ist vorzugsweise zur Erzeugung von Oszillator-Frequenzen fo im Millimeterwellenbereich und/oder von mindestens 30 GHz und/oder höchstens 1 THz, vorzugsweise höchstens 500 GHz, insbesondere höchstens 300 GHz, ausgebildet. Bevorzugt ist er zur Erzeugung von Frequenzen zwischen 60 GHz und 90 GHz geeignet. Die Vervielfacher-Frequenz fv liegt vorzugsweise ebenfalls im Millimeterwellenbereich, also zwischen 30 GHz und 300 GHz. Bei einer bevorzugten Vervielfachung um einen Faktor zwei liegt die Vervielfacher-Frequenz fv im Beispiel zwischen 120 GHz und 180 GHz.

Die Leistungssteuerung 14 ist erfindungsgemäß dazu ausgebildet, durch Steuerung der Energieversorgung 12 des Frequenzvervielfacher-Kerns 11 die Ausgangsleistung Pv der Frequenzgeneratoranordnung 1 in einer Anlaufphase und/oder in einer Abschaltphase der Frequenzgeneratoranordnung 1, des Oszillators 2 und/oder einer dem Oszillator 2 zugeordneten Regelung zu reduzieren.

Insbesondere ist die Leistungssteuerung 14 dazu ausgebildet, durch Steuerung der Energieversorgung 12 des Frequenzvervielfacher-Kerns 11 die Ausgangsleistung Pv der Frequenzgeneratoranordnung 1 zu reduzieren, wenn der Oszillator 2 einschwingt oder wenn eine Regelung der Oszillator-Frequenz fo noch keinen stationären Zustand erreicht oder den stationären Zustand verlassen hat. Hierdurch kann die Emission von Störungen vermieden werden.

Die Frequenzgeneratoranordnung 1 kann einen Regelkreis 48 aufweisen, mit dem die Ausgangsleistung Pv des Ausgangssignals 9 durch die Steuerung der Energieversorgung 12 des Frequenzvervielfacher-Kerns 11 auf eine Führungsgröße 49 regelbar ist. Der Regelkreis 48 ist in Fig. 1 angedeutet.

Die Führungsgröße 49 kann ein über die Vervielfacher-Frequenz fv, Oszillator-Frequenz fo und/oder Zeit vorgegebener fester Wert oder vorgegebener Verlauf sein. **In** Fig. 1 ist symbolisch ein über die Zeit

Die Frequenzgeneratoranordnung 1 kann einen Leistungsmesser 50 zur Messung der Ausgangsleistung Pv des Ausgangssignals 9 aufweisen. Der Leistungsmesser 50 ist vorzugsweise unmittelbar oder mittelbar, insbesondere über ein Filter 40 und/oder einen Verstärker 41, mit dem Ausgang 10 des Frequenzvervielfachers 7 und/oder des Frequenzvervielfacher-Kerns 11 gekoppelt sein. Entsprechend der Leistungsmesser 50 einen Leistungswert oder eine hierzu korrespondierende Messgröße als gemessene Ausgangsleistung Pv bestimmen. Der Leistungsmesser 50 ist in Fig. 1 an unterschiedlichen möglichen Positionen gestrichelt schematisch dargestellt, ist jedoch in der Regel nur einmalig implementiert und kann auch an einer sonstigen Position vorgesehen sein, an der die Ausgangsleistung Pv bestimmbar ist.

Wenn mehrere Frequenzvervielfacher 7 vorgesehen sind, können auch mehrere Regelkreise 48 zu deren Regelung verwendet werden bzw. vorgesehen sein, auch wenn in Fig. 1 nur ein Regelkreis 48 dargestellt ist. Ferner kann auch der Frequenzvervielfacher 7 des Empfangspfads bzw. Radar-Receivers 42 steuer- bzw. regelbar sein, auch wenn in Fig. 1 der Übersichtlichkeit wegen kein Steuereingang 13 eingezeichnet ist. In diesem Fall können die Ausgangsleistungen Pv der Frequenzvervielfacher 7 separat gesteuert bzw. geregelt werden.

Der Regelkreis 48 weist vorzugsweise einen Regler 51 auf, der dazu ausgebildet ist, die gemessene Ausgangsleistung Pv mit der Führungsgröße 49 zu vergleichen und durch die Steuerung der Energieversorgung 12 des Frequenzvervielfacher-Kerns 11 die Ausgangsleistung Pv auf die Führungsgröße 49 zu regeln. Insbesondere bildet der Regler 51 die Differenz zwischen der gemessenen Ausgangsleistung Pv und der Führungsgröße 49 und erzeugt auf Basis dieser Differenz das Steuersignal VCTRL, mit dem die Ausgangsleistung Pv entsprechend angepasst wird, sodass die Differenz ausgeregelt bzw. zumindest im Wesentlichen zu Null geregelt wird.

Die Leistungssteuerung 14 kann ein Teil des Reglers 51 sein. Hierbei kann der Regler 51 mit der Leistungssteuerung 14 auf Basis der Differenz die Energieversorgung 12 steuern. Die Leistungssteuerung 14 kann alternativ oder zusätzlich, insbesondere zeitweilig bzw. in den Intervallen 15 die Regelung außer Kraft setzen oder durch Anpassung der Führungsgröße 49 beeinflussen, insbesondere sodass die Ausgangsleistung Pv reduziert und/oder reduzierbar ist.

Insbesondere kann die Ausgangsleistung Pv des Ausgangssignals 9, wenn es in Form eines/des Radarsignals, vorzugsweise eines/des FMCW-Signals 22, insbesondere einer/der Frequenzrampe 23 vorliegt, mit dem Regelkreis 48 vorzugsweise auf die Führungsgröße 49, insbesondere den festen Wert, regelbar sein. Hierdurch können Schwankungen der Ausgangsleistung Pv über der Frequenz, die aufgrund ungewünschter Effekte der verwendeten elektrischen Bauelemente in der Regel mehr oder weniger unvermeidbar und störend sind, kompensiert werden.

Die Ausgangsleistung Pv entspricht vorzugsweise der Amplitude des Ausgangssignals 9 oder korrespondiert hierzu. Der Leistungsmesser 50 wird auch als (HF-) PWR Detektor bezeichnet. Er kann als Spannungs- bzw. Spannungsamplituden-Detektor ausgebildet sein, da entsprende Werte bei gegebenem Bezugswiderstand zur Ausgangsleistung Pv korrespondieren bzw. hierin umgerechnet werden können. Auf dieser Basis kann mit anderen Worten eine Regelung der Leistung bzw. der (Spannungs-) Amplitude des Ausgangssignals 9 auf einen konstanten Wert während der Erzeugung der FMCW-Rampe (als Ausgangssignal 9) erfolgen. Hierzu kann der PWR-Detektor den Frequenzvervielfacher 7, insbesondere Frequenzverdoppler, steuern, um den Amplitudengang des Ausgangssignal 9 auszuregeln während der Erzeugung bzw. dem Verlauf der FMCW-Rampe.

Weiter betrifft die vorliegende Erfindung ein Verfahren zur Steuerung der Ausgangsleistung Pv eines Ausgangssignals 9 einer Frequenzgeneratoranordnung 1 aufweisend einen Frequenzvervielfacher 7 und einen Oszillator 3, der ausgangsseitig mit einem Eingang 8 des Frequenzvervielfachers 7 zur Erzeugung eines Ausgangssignals 9 der Frequenzgeneratoranordnung 1 mit einer Vervielfacher-Frequenz fv, die einem Vielfachen der Oszillator-Frequenz fo entspricht, gekoppelt ist,
wobei der Frequenzvervielfacher 7 einen Frequenzvervielfacher-Kern 11 aufweist, der für die Frequenzvervielfachung unmittelbar ursächlich ist, wobei der Frequenzvervielfacher-Kern 11 eine Energieversorgung 12 aufweist, und wobei die Frequenzgeneratoranordnung 1 einen Steuereingang 13 zur Steuerung der Energieversorgung 12 des Frequenzvervielfacher-Kerns 11 aufweist, wodurch eine Ausgangsleistung Pv des Ausgangssignals 9 durch die Steuerung der Energieversorgung 12 des Frequenzvervielfacher-Kerns 11 eingestellt wird.

Vorzugsweise erfolgt die Steuerung der Energieversorgung durch Betrieb der Frequenzgeneratoranordnung 1 und seiner Komponenten in der beschriebenen Weise, wobei entsprechende Vorteile und Eigenschaften erreicht werden können.

### Bezugszeichenliste:

- 1: Frequenzgeneratoranordnung
- 2: Oszillator
- 3: Oszillator-Signal
- 4: Oszillator-Ausgang
- ▪5: Oszillator-Steuereingang
- ▪6: PLL
- ▪7.: Frequenzvervielfacher
- ▪8.: Vervielfacher-Eingang
- ▪9.: Ausgangssignal
- ▪10: Vervielfacher-Ausgang
- ▪11: Frequenzvervielfacher-Kern
- ▪12: Energieversorgung
- ▪13: Steuereingang
- ▪14: Leistungssteuerung
- ▪15: Intervall
- 16: Interferenz
- ▪17: externes Signal
- ▪18: Interferenzdetektor
- ▪19: Oszillatorsteuerung
- ▪20: Referenz
- ▪21: Frequenzgradient
- ▪22: FMCW-Signal
- ▪23: Frequenzrampe
- ▪24: Stromquelle
- ▪25: Stromspiegelschaltung
- ▪26: Referenztransistor
- ▪27: Stromspiegel
- ▪28: Referenztransistor
- ▪29: Widerstand (Referenzstrom)
- ▪30: Steuertransistor
- ▪31: Steuertransistor
- ▪32: Last
- ▪33: Erste Differenzstufe
- ▪34: Zweite Differenzstufe
- ▪35: Koppelnetzwerk
- ▪36: Kondensator
- ▪37: Wellenleitung
- ▪38: Radar-Transmitter
- ▪39: Radar-Antenne
- ▪40: Filter
- ▪41: Leistungsverstärker
- ▪42: Radar-Receiver
- ▪43: Mischer
- ▪44: Empfangssignal
- ▪45: Signaleingang
- ▪46: Steuereingang
- ▪47: Radar-System
- ▪48: Regelkreis
- ▪49: Führungsgröße
- ▪50: Leistungsmesser
- ▪51: Regler

- ▪fo: Oszillator-Frequenz
- ▪Po: Oszillator-Ausgangsleistung

- ▪fv: Vervielfacher-Frequenz
- ▪Pv: Vervielfacher-Ausgangsleistung

- ▪Iv: Kernstrom

- Us: Steuerspannung

## Patentansprüche

1. Frequenzgeneratoranordnung (1) mit einem Oszillator (2) zur Erzeugung eines Oszillator-Signals (3) mit einer Oszillator-Frequenz (fo) und einem Oszillator-Ausgang (4) zur Abgabe des Oszillator-Signals (3), wobei die Frequenzgeneratoranordnung (1) weiter einen mit dem Oszillator-Ausgang (4) gekoppelten Frequenzvervielfacher (7) zur Erzeugung eines Ausgangssignals (9) der Frequenzgeneratoranordnung (1) mit einer Vervielfacher-Frequenz (fv) aufweist, die einem Vielfachen der Oszillator-Frequenz (fo) entspricht,
wobei der Frequenzvervielfacher (7) einen Frequenzvervielfacher-Kern (11) aufweist, der für die Frequenzvervielfachung unmittelbar ursächlich ist, wobei der Frequenzvervielfacher-Kern (11) eine Energieversorgung (12) aufweist, und wobei die Frequenzgeneratoranordnung (1) einen Steuereingang (13) zur Steuerung der Energieversorgung (12) des Frequenzvervielfacher-Kerns (11) aufweist, wodurch eine Ausgangsleistung (Pv) des Ausgangssignals (9) durch die Steuerung der Energieversorgung (12) des Frequenzvervielfacher-Kerns (11) einstellbar ist, und
**dadurch gekennzeichnet, dass** die Frequenzgeneratoranordnung (1) einen Regelkreis (48) aufweist, mit dem die Ausgangsleistung (Pv) des Ausgangssignals (9) durch die Steuerung der Energieversorgung (12) des Frequenzvervielfacher-Kerns (11) auf eine Führungsgröße (49) regelbar ist.

2. Frequenzgeneratoranordnung (1) nach Anspruch 1, **dadurch gekennzeichnet, dass** die Führungsgröße (49) ein über die Vervielfacher-Frequenz (fv), Oszillator-Frequenz (fo) und/oder Zeit vorgegebener fester Wert oder vorgegebener Verlauf ist.

3. Frequenzgeneratoranordnung (1) nach Anspruch 1 oder 2, **dadurch gekennzeichnet, dass** die Frequenzgeneratoranordnung (1) einen Leistungsmesser (50) zur Messung der Ausgangsleistung (Pv) des Ausgangssignals (9) und der Regelkreis (48) einen Regler (51) aufweist, der dazu ausgebildet ist, die gemessene Ausgangsleistung (Pv) mit der Führungsgröße (49) zu vergleichen und durch die Steuerung der Energieversorgung (12) des Frequenzvervielfacher-Kerns (11) die Ausgangsleistung (Pv) auf eine Führungsgröße (49) zu regeln.

4. Frequenzgeneratoranordnung (1) nach Anspruch 2, **dadurch gekennzeichnet, dass** die Ausgangsleistung (Pv) mit dem Regelkreis (48) auf die Führungsgröße (49), insbesondere den festen Wert, regelbar ist, während des Ausgangssignal (9) in Form eines/des Radarsignals, vorzugsweise eines FMCW-Signals (22), insbesondere einer Frequenzrampe (23) erzeugt wird.

5. Frequenzgeneratoranordnung (1) nach einem der voranstehenden Ansprüche, **dadurch gekennzeichnet, dass** die Energieversorgung (12) eine über den Steuereingang (13) steuerbare Stromquelle (24) ist oder aufweist, insbesondere eine mit dem Steuereingang (13) gekoppelte Stromspiegelschaltung (25).

6. Frequenzgeneratoranordnung (1) nach einem der voranstehenden Ansprüche, **dadurch gekennzeichnet, dass** die Frequenzgeneratoranordnung (1) einen Filter (40) aufweist, vorzugsweise getrennt von dem Frequenzvervielfacher (7) und/oder realisiert mit einem oder mehreren Schwingkreisen und/oder Wellenleitungen (37), insbesondere als Last (32) des Frequenzvervielfacher-Kerns (11), sodass die Oszillator-Frequenz (fo) im Ausgangssignal (9) unterdrückt oder unterdrückbar ist.

7. Frequenzgeneratoranordnung (1) nach einem der voranstehenden Ansprüche, **dadurch gekennzeichnet, dass** der Frequenzvervielfacher (7) eine Gilbertzelle aufweist oder auf einer solchen basiert, die ausgangsseitig das Ausgangssignal (9) bei einer vielfachen, insbesondere doppelten, Oszillator-Frequenz (fo) bevorzugt differenziell zur Verfügung stellt.

8. Frequenzgeneratoranordnung (1) nach einem der voranstehenden Ansprüche, **dadurch gekennzeichnet, dass** die Frequenzgeneratoranordnung (1) eine Oszillator-steuerung (19) aufweist, die dazu ausgebildet ist, durch Steuerung des Oszillators (2) Radarsignale, vorzugsweise FMCW-Signale (22), insbesondere Frequenzrampen (23), zu erzeugen.

9. Radar-Transmitter (38), der eine Frequenzgeneratoranordnung (1) nach einem der voranstehenden Ansprüche aufweist und mit einer Radar-Antenne (39) koppelbar oder gekoppelt ist, sodass das Ausgangssignal (9) der Frequenzgeneratoranordnung (1) über die Radar-Antenne (39) emittierbar ist.

10. Radar-Receiver (42) aufweisend eine Frequenzgeneratoranordnung (1) nach einem der Ansprüche 1 bis 8 und mindestens einen Mischer (43) zum Umsetzen einer Frequenz eines Empfangssignals (44), das mittels einer mit dem Mischer (43) koppelbaren oder gekoppelten Radar-Antenne (39) empfangbar ist, wobei der Mischer (43) mit einem Vervielfacher-Ausgang (10) der Frequenzgeneratoranordnung (1) gekoppelt ist, sodass das Ausgangssignal (9) der Frequenzgeneratoranordnung (1) ein Lokaloszillatorsignal für den Mischer (43) bildet, und das Empfangssignal (44) mit dem Mischer (43) in seiner Frequenz umsetzbar ist.

11. Radar-System (47) mit einem Radar-Transmitter (38) nach Anspruch 9 und/oder einem Radar-Receiver (42) nach Anspruch 10, vorzugsweise wobei das Radar-System (47) mindestens eine Radar-Antenne (39) aufweist, wobei die Radar-Antenne (39) oder eine der Radar-Antennen (39) mit dem Radar-Transmitter (38) gekoppelt oder koppelbar ist, sodass das Ausgangssignal (9) mittels der Radar-Antennen (39) emittierbar ist, und dass die Radar-Antenne (39) oder eine andere der Radar-Antennen (39) mit dem Radar-Receiver (42) gekoppelt oder koppelbar ist, sodass ein mit der Radar-Antenne (39) oder mit der anderen der Radar-Antennen (39) empfangenes oder empfangbares Empfangssignal (44) mit dem Mischer (43) in seiner Frequenz umsetzbar ist.

12. Verwendung eines Frequenzvervielfachers (7) einer Frequenzgeneratoranordnung (1),
wobei die Frequenzgeneratoranordnung (1) einen Oszillator (3) aufweist, der ausgangsseitig mit einem Eingang (8) des Frequenzvervielfachers (7) zur Erzeugung eines Ausgangssignals (9) der Frequenzgeneratoranordnung (1) mit einer Vervielfacher-Frequenz (fv), die einem Vielfachen der Oszillator-Frequenz (fo) entspricht, gekoppelt ist, wobei der Frequenzvervielfacher (7) einen Frequenzvervielfacher-Kern (11) aufweist, der für die Frequenzvervielfachung unmittelbar ursächlich ist, wobei der Frequenzvervielfacher-Kern (11) eine Energieversorgung (12) aufweist, und wobei die Frequenzgeneratoranordnung (1) einen Steuereingang (13) zur Steuerung der Energieversorgung (12) des Frequenzvervielfacher-Kerns (11) aufweist,
und **dadurch gekennzeichnet, dass** die Frequenzgeneratoranordnung (1) einen Regelkreis (48) aufweist, mit dem die Ausgangsleistung (Pv) des Ausgangssignals (9) durch die Steuerung der Energieversorgung (12) des Frequenzvervielfacher-Kerns (11) auf eine Führungsgröße (49) regelbar ist,
wobei die Ausgangsleistung (Pv) eines Ausgangssignals (9) der Frequenzgeneratoranordnung (1) auf die Führungsgröße (49) geregelt wird.

13. Verfahren zur Steuerung einer Ausgangsleistung (Pv) eines Ausgangssignals (9) einer Frequenzgeneratoranordnung (1) aufweisend einen Frequenzvervielfacher (7) und einen Oszillator (3), der ausgangsseitig mit einem Eingang (8) des Frequenzvervielfachers (7) zur Erzeugung eines Ausgangssignals (9) der Frequenzgeneratoranordnung (1) mit einer Vervielfacher-Frequenz (fv), die einem Vielfachen der Oszillator-Frequenz (fo) entspricht, gekoppelt ist,
wobei der Frequenzvervielfacher (7) einen Frequenzvervielfacher-Kern (11) aufweist, der für die Frequenzvervielfachung unmittelbar ursächlich ist, wobei der Frequenzvervielfacher-Kern (11) eine Energieversorgung (12) aufweist, und wobei die Frequenzgeneratoranordnung (1) einen Steuereingang (13) zur Steuerung der Energieversorgung (12) des Frequenzvervielfacher-Kerns (11) aufweist, und
**dadurch gekennzeichnet, dass** die Frequenzgeneratoranordnung (1) einen Regelkreis (48) aufweist, mit dem die Ausgangsleistung (Pv) des Ausgangssignals (9) durch die Steuerung der Energieversorgung (12) des Frequenzvervielfacher-Kerns (11) auf eine Führungsgröße (49) geregelt wird, wobei die Ausgangsleistung (Pv) des Ausgangssignals (9) durch die Steuerung der Energieversorgung (12) des Frequenzvervielfacher-Kerns (11) gesteuert wird.

14. Verfahren nach Anspruch 13, **dadurch gekennzeichnet, dass** die Ausgangsleistung (Pv) des Ausgangssignals (9) durch die Steuerung der Energieversorgung (12) des Frequenzvervielfacher-Kerns (11) auf die Führungsgröße (49) geregelt wird, vorzugsweise
wobei die Führungsgröße (49) ein über die Vervielfacher-Frequenz (fv), Oszillator-Frequenz (fo) und/oder Zeit vorgegebener fester Wert oder vorgegebener Verlauf ist; und/oder
wobei die Ausgangsleistung (Pv) des Ausgangssignals (9) gemessen und die gemessene Ausgangsleistung (Pv) mit der Führungsgröße (49) verglichen und die Energieversorgung (12) des Frequenzvervielfacher-Kerns (11) auf Basis des Vergleichs gesteuert wird, sodass die Ausgangsleistung (Pv) auf die Führungsgröße (49) geregelt wird; und/oder
wobei die Ausgangsleistung (Pv) des Ausgangssignals (9) mit dem Regelkreis (48) auf die Führungsgröße (49), insbesondere den festen Wert, geregelt wird, während das Ausgangssignal (9) in Form eines/des Radarsignals, vorzugsweise eines/des FMCW-Signals (22), insbesondere einer/der Frequenzrampe (23), erzeugt wird.

## Claims

1. Frequency generator arrangement (1) comprising an oscillator (2) for generating an oscillator signal (3) having an oscillator frequency (fo) and an oscillator output (4) for outputting the oscillator signal (3), wherein the frequency generator arrangement (1) further comprises a frequency multiplier (7) coupled to the oscillator output (4) for generating an output signal (9) of the frequency generator arrangement (1) with a multiplier frequency (fv) corresponding to a multiple of the oscillator frequency (fo),
wherein the frequency multiplier (7) comprises a frequency multiplier core (11) directly causative of the frequency multiplication, wherein the frequency multiplier core (11) comprises a power supply (12), and wherein the frequency generator arrangement (1) comprises a control input (13) for controlling the power supply (12) of the frequency multiplier core (11), whereby an output power (Pv) of the output signal (9) is adjustable by controlling the power supply (12) of the frequency multiplier core (11), and
**characterized in that** the frequency generator arrangement (1) comprises a control loop (48) by means of which the output power (Pv) of the output signal (9) can be feedback-controlled to a reference variable (49) by controlling the power supply (12) of the frequency multiplier core (11).

2. Frequency generator arrangement (1) according to claim 1, **characterized in that** the reference variable (49) is a fixed value or progression predetermined via the multiplier frequency (fv), oscillator frequency (fo) and/or time.

3. Frequency generator arrangement (1) according to claim 1 or 2, **characterized in that** the frequency generator arrangement (1) comprises a power meter (50) for measuring the output power (Pv) of the output signal (9) and the control loop (48) comprises a controller (51) which is designed to compare the measured output power (Pv) with the reference variable (49) and to feedback-control the output power (Pv) to a reference variable (49) by controlling the power supply (12) of the frequency multiplier core (11).

4. Frequency generator arrangement (1) according to claim 2, **characterized in that** the output power (Pv) is feedback-controllable with the control loop (48) to the reference variable (49), in particular the fixed value, while the output signal (9) is generated in the form of a/the radar signal, preferably an FMCW signal (22), in particular a frequency ramp (23).

5. Frequency generator arrangement (1) according to one of the preceding claims, **characterized in that** the power supply (12) is or comprises a current source (24) which can be controlled via the control input (13), in particular a current mirror circuit (25) coupled to the control input (13).

6. Frequency generator arrangement (1) according to one of the preceding claims, **characterized in that** the frequency generator arrangement (1) comprises a filter (40), preferably separate from the frequency multiplier (7) and/or realized with one or more oscillating circuits and/or waveguides (37), in particular as a load (32) of the frequency multiplier core (11), so that the oscillator frequency (fo) in the output signal (9) is suppressed or can be suppressed.

7. Frequency generator arrangement (1) according to one of the preceding claims, **characterized in that** the frequency multiplier (7) comprises a Gilbert cell or is based on such a cell, which makes the output signal (9) available on the output side at a multiple, in particular double, oscillator frequency (fo), preferably differentially.

8. Frequency generator arrangement (1) according to one of the preceding claims, **characterized in that** the frequency generator arrangement (1) comprises an oscillator control (19) which is configured to generate radar signals, preferably FMCW signals (22), in particular frequency ramps (23), by controlling the oscillator (2).

9. Radar transmitter (38) comprising a frequency generator arrangement (1) according to one of the preceding claims and being couplable or coupled to a radar antenna (39) so that the output signal (9) of the frequency generator arrangement (1) is emittable via the radar antenna (39).

10. Radar receiver (42) comprising a frequency generator arrangement (1) according to any one of claims 1 to 8 and at least one mixer (43) for converting a frequency of a received signal (44) receivable by means of a radar antenna (39) couplable or coupled to the mixer (43), wherein the mixer (43) is coupled to a multiplier output (10) of the frequency generator arrangement (1) so that the output signal (9) of the frequency generator arrangement (1) forms a local oscillator signal for the mixer (43), and the received signal (44) can be converted in its frequency by the mixer (43).

11. Radar system (47) comprising a radar transmitter (38) according to claim 9 and/or a radar receiver (42) according to claim 10, preferably wherein the radar system (47) comprises at least one radar antenna (39), wherein the radar antenna (39) or one of the radar antennas (39) is coupled or couplable to the radar transmitter (38), so that the output signal (9) can be emitted by means of the radar antennas (39), and in that the radar antenna (39) or another of the radar antennas (39) is coupled or couplable to the radar receiver (42), so that a received signal (44) received or receivable with the radar antenna (39) or with the other of the radar antennas (39) can be converted in its frequency with the mixer (43).

12. Use of a frequency multiplier (7) of a frequency generator arrangement (1),
the frequency generator arrangement (1) comprising an oscillator (3) which is coupled on the output side to an input (8) of the frequency multiplier (7) for generating an output signal (9) of the frequency generator arrangement (1) with a multiplier frequency (fv), which corresponds to a multiple of the oscillator frequency (fo), wherein the frequency multiplier (7) comprises a frequency multiplier core (11) directly causative of the frequency multiplication, wherein the frequency multiplier core (11) comprises a power supply (12), and wherein the frequency generator arrangement (1) comprises a control input (13) for controlling the power supply (12) of the frequency multiplier core (11), and
**characterized in that** the frequency generator arrangement (1) comprises a control loop (48) by means of which the output power (Pv) of the output signal (9) can be feedback-controlled to a reference variable (49) by controlling the power supply (12) of the frequency multiplier core (11),
wherein the output power (Pv) of an output signal (9) of the frequency generator arrangement (1) is feedback-controlled to the reference variable (49).

13. Method for controlling an output power (Pv) of an output signal (9) of a frequency generator arrangement (1) comprising a frequency multiplier (7) and an oscillator (3) which is coupled on the output side to an input (8) of the frequency multiplier (7) for generating an output signal (9) of the frequency generator arrangement (1) with a multiplier frequency (fv), which corresponds to a multiple of the oscillator frequency (fo),
wherein the frequency multiplier (7) comprises a frequency multiplier core (11) directly causative of the frequency multiplication, wherein the frequency multiplier core (11) comprises a power supply (12), and wherein the frequency generator arrangement (1) comprises a control input (13) for controlling the power supply (12) of the frequency multiplier core (11), and
**characterized in that** the frequency generator arrangement (1) comprises a control loop (48) by means of which the output power (Pv) of the output signal (9) is feedback-controlled to a reference variable (49) by controlling the power supply (12) of the frequency multiplier core (11), wherein the output power (Pv) of the output signal (9) is controlled by controlling the power supply (12) of the frequency multiplier core (11).

14. Method according to claim 13, **characterized in that** the output power (Pv) of the output signal (9) is feedback-controlled to the reference variable (49) by controlling the power supply (12) of the frequency multiplier core (11),
preferably
wherein the reference variable (49) is a fixed value or course predetermined via the multiplier frequency (fv), oscillator frequency (fo) and/or time; and/or
wherein the output power (Pv) of the output signal (9) is measured and the measured output power (Pv) is compared with the reference variable (49) and the power supply (12) of the frequency multiplier core (11) is controlled on the basis of the comparison so that the output power (Pv) is feedback-controlled to the reference variable (49); and/or
wherein the output power (Pv) of the output signal (9) is feedback-controlled with the control loop (48) to the reference variable (49), in particular the fixed value, while the output signal (9) is generated in the form of a/the radar signal, preferably a/the FMCW signal (22), in particular a/the frequency ramp (23).

## Revendications

1. Agencement de générateur de fréquence (1) comprenant un oscillateur (2) pour générer un signal d'oscillateur (3) avec une fréquence d'oscillateur (fo) et une sortie d'oscillateur (4) pour délivrer le signal d'oscillateur (3), l'agencement de générateur de fréquence (1) présentant en outre un multiplicateur de fréquence (7) couplé à la sortie d'oscillateur (4) pour générer un signal de sortie (9) de l'agencement de générateur de fréquence (1) avec une fréquence de multiplicateur (fv) qui correspond à un multiple de la fréquence d'oscillateur (fo),
le multiplicateur de fréquence (7) présentant un noyau de multiplicateur de fréquence (11) qui est directement à l'origine de la multiplication de fréquence, le noyau de multiplicateur de fréquence (11) présentant une alimentation en énergie (12), et l'agencement de générateur de fréquence (1) présentant une entrée de commande (13) pour commander l'alimentation en énergie (12) du noyau de multiplicateur de fréquence (11), moyennant quoi une puissance de sortie (Pv) du signal de sortie (9) peut être réglée par la commande de l'alimentation en énergie (12) du noyau de multiplicateur de fréquence (11), et
**caractérisé en ce que** l'agencement de générateur de fréquence (1) présente un circuit de régulation (48) avec lequel la puissance de sortie (Pv) du signal de sortie (9) peut être régulée par la commande de l'alimentation en énergie (12) du noyau de multiplicateur de fréquence (11) à une grandeur de référence (49).

2. Agencement de générateur de fréquence (1) selon la revendication 1, **caractérisé en ce que** la grandeur de référence (49) est une valeur fixe prédéfinie ou une courbe prédéfinie sur la fréquence de multiplicateur (fv), la fréquence d'oscillateur (fo) et/ou le temps.

3. Agencement de générateur de fréquence (1) selon la revendication 1 ou 2, **caractérisé en ce que** l'agencement de générateur de fréquence (1) présente un mesureur de puissance (50) pour mesurer la puissance de sortie (Pv) du signal de sortie (9) et le circuit de régulation (48) présente un régulateur (51) qui est réalisé pour comparer la puissance de sortie (Pv) mesurée à la grandeur de référence (49) et pour réguler la puissance de sortie (Pv) à une grandeur de référence (49) par la commande de l'alimentation en énergie (12) du noyau de multiplicateur de fréquence (11).

4. Agencement de générateur de fréquence (1) selon la revendication 2, **caractérisé en ce que** la puissance de sortie (Pv) peut être régulée avec le circuit de régulation (48) à la grandeur de référence (49), en particulier la valeur fixe, pendant que le signal de sortie (9) est généré sous la forme d'un/du signal radar, de préférence d'un signal FMCW (22), en particulier d'une rampe de fréquence (23).

5. Agencement de générateur de fréquence (1) selon l'une quelconque des revendications précédentes, **caractérisé en ce que** l'alimentation en énergie (12) est ou présente une source de courant (24) pouvant être commandée par le biais de l'entrée de commande (13), en particulier un circuit miroir de courant (25) couplé à l'entrée de commande (13).

6. Agencement de générateur de fréquence (1) selon l'une quelconque des revendications précédentes, **caractérisé en ce que** l'agencement de générateur de fréquence (1) présente un filtre (40), de préférence séparé du multiplicateur de fréquence (7) et/ou réalisé avec un ou plusieurs circuits oscillants et/ou lignes d'onde (37), en particulier en tant que charge (32) du noyau de multiplicateur de fréquence (11), de sorte que la fréquence d'oscillateur (fo) dans le signal de sortie (9) est supprimée ou peut être supprimée.

7. Agencement de générateur de fréquence (1) selon l'une quelconque des revendications précédentes, **caractérisé en ce que** le multiplicateur de fréquence (7) présente une cellule de Gilbert ou est basé sur une telle, laquelle met à disposition côté sortie le signal de sortie (9), de préférence de manière différentielle, à une fréquence d'oscillateur (fo) multiple, en particulier double.

8. Agencement de générateur de fréquence (1) selon l'une quelconque des revendications précédentes, **caractérisé en ce que** l'agencement de générateur de fréquence (1) présente une commande d'oscillateur (19) qui est réalisée pour générer des signaux radar, de préférence des signaux FMCW (22), en particulier des rampes de fréquence (23), par la commande de l'oscillateur (2).

9. Émetteur radar (38), lequel présente un agencement de générateur de fréquence (1) selon l'une quelconque des revendications précédentes et peut être couplé ou est couplé à une antenne radar (39), de sorte que le signal de sortie (9) de l'agencement de générateur de fréquence (1) peut être émis par le biais de l'antenne radar (39).

10. Récepteur radar (42) présentant un agencement de générateur de fréquence (1) selon l'une quelconque des revendications 1 à 8 et au moins un mélangeur (43) pour convertir une fréquence d'un signal de réception (44) qui peut être reçu au moyen d'une antenne radar (39) pouvant être couplée ou étant couplée au mélangeur (43), le mélangeur (43) étant couplé à une sortie de multiplicateur (10) de l'agencement de générateur de fréquence (1), de sorte que le signal de sortie (9) de l'agencement de générateur de fréquence (1) forme un signal d'oscillateur local pour le mélangeur (43), et le signal de réception (44) pouvant être converti en fréquence avec le mélangeur (43).

11. Système radar (47) comprenant un émetteur radar (38) selon la revendication 9 et/ou un récepteur radar (42) selon la revendication 10, de préférence le système radar (47) présentant au moins une antenne radar (39), l'antenne radar (39) ou l'une des antennes radar (39) étant couplée ou pouvant être couplée à l'émetteur radar (38), de sorte que le signal de sortie (9) peut être émis au moyen des antennes radar (39), et l'antenne radar (39) ou une autre des antennes radar (39) étant couplée ou pouvant être couplée au récepteur radar (42), de sorte qu'un signal de réception (44) reçu ou pouvant être reçu avec l'antenne radar (39) ou avec l'autre des antennes radar (39) peut être converti en fréquence avec le mélangeur (43).

12. Utilisation d'un multiplicateur de fréquence (7) d'un agencement de générateur de fréquence (1),
l'agencement de générateur de fréquence (1) présentant un oscillateur (3) qui est couplé côté sortie à une entrée (8) du multiplicateur de fréquence (7) pour générer un signal de sortie (9) de l'agencement de générateur de fréquence (1) avec une fréquence de multiplicateur (fv) qui correspond à un multiple de la fréquence d'oscillateur (fo), le multiplicateur de fréquence (7) présentant un noyau de multiplicateur de fréquence (11) qui est directement à l'origine de la multiplication de fréquence, le noyau de multiplicateur de fréquence (11) présentant une alimentation en énergie (12), et l'agencement de générateur de fréquence (1) présentant une entrée de commande (13) pour commander l'alimentation en énergie (12) du noyau de multiplicateur de fréquence (11), et **caractérisée en ce que** l'agencement de générateur de fréquence (1) présente un circuit de régulation (48) avec lequel la puissance de sortie (Pv) du signal de sortie (9) peut être régulée par la commande de l'alimentation en énergie (12) du noyau de multiplicateur de fréquence (11) à une grandeur de référence (49),
la puissance de sortie (Pv) d'un signal de sortie (9) de l'agencement de générateur de fréquence (1) étant régulée à la grandeur de référence (49).

13. Procédé de commande d'une puissance de sortie (Pv) d'un signal de sortie (9) d'un agencement de générateur de fréquence (1) présentant un multiplicateur de fréquence (7) et un oscillateur (3) qui est couplé côté sortie à une entrée (8) du multiplicateur de fréquence (7) pour générer un signal de sortie (9) de l'agencement de générateur de fréquence (1) avec une fréquence de multiplicateur (fv) qui correspond à un multiple de la fréquence d'oscillateur (fo),
le multiplicateur de fréquence (7) présentant un noyau de multiplicateur de fréquence (11) qui est directement à l'origine de la multiplication de fréquence, le noyau de multiplicateur de fréquence (11) présentant une alimentation en énergie (12), et l'agencement de générateur de fréquence (1) présentant une entrée de commande (13) pour commander l'alimentation en énergie (12) du noyau de multiplicateur de fréquence (11), et **caractérisé en ce que** l'agencement de générateur de fréquence (1) présente un circuit de régulation (48) avec lequel la puissance de sortie (Pv) du signal de sortie (9) est régulée par la commande de l'alimentation en énergie (12) du noyau de multiplicateur de fréquence (11) à une grandeur de référence (49), la puissance de sortie (Pv) du signal de sortie (9) étant commandée par la commande de l'alimentation en énergie (12) du noyau de multiplicateur de fréquence (11).

14. Procédé selon la revendication 13, **caractérisé en ce que** la puissance de sortie (Pv) du signal de sortie (9) est régulée par la commande de l'alimentation en énergie (12) du noyau de multiplicateur de fréquence (11) à la grandeur de référence (49), de préférence
la grandeur de référence (49) étant une valeur fixe prédéfinie ou une courbe prédéfinie sur la fréquence de multiplicateur (fv), la fréquence d'oscillateur (fo) et/ou le temps ; et/ou
la puissance de sortie (Pv) du signal de sortie (9) étant mesurée et la puissance de sortie (Pv) mesurée étant comparée à la grandeur de référence (49) et l'alimentation en énergie (12) du noyau de multiplicateur de fréquence (11) étant commandée sur la base de la comparaison, de sorte que la puissance de sortie (Pv) est régulée à la grandeur de référence (49) ; et/ou
la puissance de sortie (Pv) du signal de sortie (9) étant régulée avec le circuit de régulation (48) à la grandeur de référence (49), en particulier la valeur fixe, pendant que le signal de sortie (9) est généré sous la forme d'un/du signal radar, de préférence d'un/du signal FMCW (22), en particulier d'une/de la rampe de fréquence (23).
